(19) Europäisches Patentamt
European Patent Office
Office européen des brevets

(11) EP 4 678 705 A2

(12) # EUROPÄISCHE PATENTANMELDUNG

(43) Veröffentlichungstag:
**14.01.2026 Patentblatt 2026/03**

(21) Anmeldenummer: **25201075.6**

(22) Anmeldetag: **20.12.2022**

(51) Internationale Patentklassifikation (IPC):
***C09D 171/00*** *(2006.01)*

(52) Gemeinsame Patentklassifikation (CPC):
**G01N 19/02; G02B 1/18**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **21.12.2021 DE 102021134053**

(62) Dokumentnummer(n) der früheren Anmeldung(en) nach Art. 76 EPÜ:
**22840724.3 / 4 356 185**

(71) Anmelder: **Rodenstock GmbH**
**80687 München (DE)**

(72) Erfinder:
- **BRUNNER, Hermann**
  **82234 Wessling (DE)**
- **GRAGE, Yvonne**
  **81547 München (DE)**
- **URBAN, Arne**
  **81827 München (DE)**
- **VÖGT, Michael**
  **82205 Gilching (DE)**
- **GRAU, Markus**
  **85737 Ismaning (DE)**
- **MERKELBACH, Philipp**
  **82347 Bernried (DE)**
- **KEIL, Andreas**
  **84453 Mühldorf am Inn (DE)**

(74) Vertreter: **Müller-Boré & Partner**
**Patentanwälte PartG mbB**
**Friedenheimer Brücke 21**
**80639 München (DE)**

Bemerkungen:
Diese Anmeldung ist am 09-09-2025 als Teilanmeldung zu der unter INID-Code 62 erwähnten Anmeldung eingereicht worden.

(54) **BRILLENGLAS MIT VERMINDERTEN REIBUNGSEIGENSCHAFTEN, MESSVERFAHREN ZUR BESTIMMUNG DER GLATTHEIT DES BRILLENGLASES SOWIE VERFAHREN ZUR HERSTELLUNG DES BRILLENGLASES**

(57) Die vorliegende Erfindung betrifft ein Brillenglas, aufweisend ein Substrat und eine als äußerste Schicht auf dem Substrat angeordnete funktionelle Beschichtung, dadurch gekennzeichnet, dass die funktionelle Beschichtung dem Brillenglas einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80, verleiht. Weiterhin betrifft die vorliegende Erfindung ein Verfahren zur Herstellung des Brillenglases.



Processed by Luminess, 75001 PARIS (FR)

## Beschreibung

Die vorliegende Erfindung betrifft ein Brillenglas, aufweisend ein Substrat und eine als äußerste Schicht auf dem Substrat angeordnete funktionelle Beschichtung, ein Messverfahren zur Bestimmung der Glattheit des Brillenglases sowie ein Verfahren zur Herstellung des Brillenglases.

Im Stand der Technik sind Brillengläser, welche mit einer Mehrzahl von verschiedenen Schichten vergütet sein können, bekannt. So lässt sich durch Vergüten mit einer Hartschicht das Brillenglas vor Kratzern schützen. Eine Reflexminderung lässt sich durch Vergüten mit einer Interferenz-/Entspiegelungsschicht erreichen. Das Vergüten mit einer funktionellen Beschichtung, welche mitunter auch als Topcoat oder Cleancoat bezeichnet wird, dient schließlich der Abweisung von Schmutz und Wassertropfen. Ausgehend von der Oberfläche des Brillenglases weist ein typischer Schichtaufbau die Schichtfolge Hartschicht, Interferenz-/Entspiegelungsschicht und funktionelle Beschichtung auf. Letztere stellt somit die äußerste Vergütungsschicht dar. Jede der vorstehend genannten Vergütungsschichten kann dabei aus einer einzigen Schicht oder aus einem Schichtsystem mit mehreren Schichten bestehen.

Um gegenüber Schmutz und Wassertropfen abweisend zu sein, besitzt die funktionelle Beschichtung in der Regel sowohl oleophobe als auch hydrophobe Eigenschaften. Ein Maß hierfür ist der jeweilige Kontaktwinkel, den eine entsprechende Flüssigkeit auf der Oberfläche des Brillenglases ausbildet. Hierbei gilt im Allgemeinen, dass die oleophoben und hydrophoben Eigenschaften umso ausgeprägter sind, je größer der Kontaktwinkel der jeweiligen Flüssigkeit auf der Oberfläche des Brillenglases ist. Zwar lassen sich mit einer funktionellen Beschichtung vergütete Brillengläser gut von Schmutz und Wassertropfen, welche ansonsten an die Oberfläche des Brillenglases haften würden, befreien. Dennoch muss das Brillenglas von Zeit zu Zeit gereinigt werden, etwa durch Putzen mit einem Wischgegenstand, wie beispielsweise einem Mikrofasertuch oder dergleichen. Wird das Brillenglas zuvor mit fließendem Wasser in Kontakt gebracht, bedarf es ebenfalls eines derartigen Wischgegenstandes, um das Brillenglas zu trocknen. Vorliegend wird unter einem Putzen auch ein solches Trocknen verstanden.

Grundsätzlich erfordert das Gleiten mit dem Wischgegenstand über die Oberfläche des Brillenglases einen gewissen Kraftaufwand, welcher sich zudem erhöht, wenn die Wischgeschwindigkeit zunimmt. Ist die beim Wischen aufgebrachte Kraft zu gering, bleibt der Wischgegenstand auf dem Brillenglas haften. Hierdurch kann es zu einem Rutschen der Finger über den Wischgegenstand kommen. Dies wiederum beeinträchtigt den Putzvorgang. Im Ergebnis fühlt sich die Oberfläche des Brillenglases beim Putzen mit dem Wischgegenstand nicht ausreichend glatt an.

Unter idealen Bedingungen erreicht man ein optimales Putzergebnis durch einmaliges Wischen mit einem sauberen Mikrofasertuch über die Oberfläche des Brillenglases, was auch als sogenannter "one wipe clean" bezeichnet wird. Dennoch machen die meisten Brillenträger beim Putzen des Brillenglases mehrere alternierende Putzhübe in der Breitenrichtung des Brillenglases, d.h. alternierend von links nach rechts bzw. rechts nach links. In diesem Fall wird ein Brillenglas, dessen Oberfläche sich nicht ausreichend glatt anfühlt, als besonders störend wahrgenommen.

Die im Stand der Technik bekannten Ansätze zur Vergütung eines Brillenglases mit einer funktionellen Beschichtung zielen typischerweise auf die Verbesserung der oleophoben und hydrophoben Eigenschaften ab, um so die Oberfläche des Brillenglases noch abweisender gegenüber Anhaftungen wie Schmutz und Wassertropfen zu machen. Demnach lag bei der Vergütung von Brillengläsern bislang der Fokus auf einer Verbesserung der schmutz- und wasserabweisenden Eigenschaften des Brillenglases und nicht etwa auf einem besonders leichtgängigen Wischen mit geringem Kraftaufwand.

Der vorliegenden Erfindung liegt somit die Aufgabe zugrunde, ein mit einer funktionellen Beschichtung vergütetes Brillenglas bereitzustellen, wobei dieses derart vergütet sein soll, dass neben der Abweisung von Schmutz und Wassertropfen ein besonders leichtgängiges Wischen mit geringem Kraftaufwand möglich ist. Weiterhin liegt der vorliegenden Erfindung die Aufgabe zugrunde, ein Messverfahren zur Bestimmung der Glattheit eines solchen Brillenglases sowie ein Verfahren zur Herstellung eines solchen Brillenglases bereitzustellen.

Die vorstehenden Aufgaben werden durch ein Messverfahren mit den Merkmalen des Anspruchs 1, durch ein Brillenglas mit den Merkmalen des Anspruchs 5 und durch ein Verfahren zur Herstellung eines Brillenglases mit den Merkmalen des Anspruchs 12 gelöst. Bevorzugte Ausführungsformen sind in den Unteransprüchen offenbart.

Gemäß einem ersten Aspekt der vorliegenden Erfindung wird ein Brillenglas, aufweisend ein Substrat und eine als äußerste Schicht auf dem Substrat angeordnete funktionelle Beschichtung, bereitgestellt, wobei das erfindungsgemäße Brillenglas dadurch gekennzeichnet ist, dass die funktionelle Beschichtung dem Brillenglas einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80, verleiht.

Aufgrund der funktionellen Beschichtung, welche durch einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80, gekennzeichnet ist, erlaubt das erfindungsgemäße Brillenglas ein besonders leichtgängiges Wischen mit geringem Kraftaufwand. Zudem ist der Kraftaufwand bei zunehmender Wischgeschwindigkeit nur geringfügig erhöht. So fühlt sich die Oberfläche des erfindungsgemäßen Brillenglases beim Wischen besonders glatt an, was haptisch wiederum als sehr angenehm empfunden wird. Es wird damit als sehr hochwertig eingeschätzt.

Darüber hinaus besitzt die funktionelle Beschichtung des erfindungsgemäßen Brillenglases sowohl oleophobe als auch hydrophobe Eigenschaften, weswegen es zudem eine ausgezeichnete Schmutz- und Wasserabweisung und damit insgesamt eine ausgezeichnete Reinig- und Handhabbarkeit aufweist.

Im Folgenden wird das erfindungsgemäße Brillenglas näher beschrieben. Die haptischen Glattheitskoeffizienten HGK und R_HGK sowie deren Bestimmung werden im Zusammenhang mit dem erfindungsgemäßen Messverfahren zur Bestimmung der Glattheit eines Brillenglases erläutert.

Das erfindungsgemäße Brillenglas weist ein Substrat auf. Das Substrat des erfindungsgemäßen Brillenglases unterliegt als solches keinen besonderen Einschränkungen. In Bezug auf seine geometrische Form etwa kann das Substrat grundsätzlich planparallel, bikonkav, plankonkav, konvexkonkav, konkavkonvex, plankonvex oder bikonvex sein. Typischerweise ist die Vorderfläche des Substrats konvex geformt, während die zum Auge liegende Rückfläche konkav geformt ist. Hierbei wird die geometrische Form bei Brillengläsern mit positiver Brechkraft als konkavkonvex und bei Brillengläsern mit negativer Brechkraft als konvexkonkav bezeichnet. Was die geometrische Form anbelangt, sind weiterhin noch Substrate für Gleitsichtgläser zu nennen. Diese werden im Stand der Technik auch als Progressivgläser bezeichnet.

In Bezug auf das Grundmaterial ist das Substrat des erfindungsgemäßen Brillenglases ebenfalls nicht weiter eingeschränkt. So kann das Substrat aus Mineralglas oder aus Kunststoffglas gefertigt sein. Kunststoffglas hat gegenüber Mineralglas den Vorteil, dass es eine geringere Dichte und damit ein geringeres Gewicht aufweist, was zu einem angenehmeren Tragegefühl führt. Weiterhin weisen aus Kunststoffglas gefertigte Brillengläser eine erhöhte Bruchsicherheit auf. Als Kunststoffmaterialien kommen vorliegend beispielsweise Polythiourethan, Polymethylmethacrylat, Polycarbonat, Polyacrylat oder Polydiethylenglycolbisallylcarbonat sowie Kombinationen hiervon in Frage, wobei prinzipiell auch andere transparente Kunststoffmaterialien verwendet werden können.

Das Grundmaterial des Substrats wird dabei so gewählt, dass das Brillenglas typischerweise einen Brechungsindex in einem Bereich von 1,45 bis 1,90, insbesondere in einem Bereich von 1,45 bis 1,55, in einem Bereich von 1,59 bis 1,68 oder in einem Bereich von 1,73 bis 1,75 aufweist. Es können somit Substrate aus Standardglas mit einem Brechungsindex von etwa 1,50, aus Qualitätsglas mit einem Brechungsindex von etwa 1,60 bzw. 1,67 oder aus Premiumglas mit einem Brechungsindex von etwa 1,74 verwendet werden.

Wie eingangs erwähnt, kann auf das Substrat zunächst eine Hartschicht aufgebracht sein. Dies ist insbesondere dann sinnvoll, wenn das Substrat aus Kunststoffglas gefertigt ist, da es sich hierbei um ein vergleichsweise weiches Material handelt und somit die Anfälligkeit eines daraus gefertigten Brillenglases gegenüber Kratzern höher ist als bei Mineralglas. Die Hartschicht kann einen ein- oder mehrschichtigen Aufbau aufweisen. Zur Herstellung der Hartschicht können verschiedene Materialien und Verfahren eingesetzt werden, welche ein Fachmann in geeigneter Weise auswählt. Ebenfalls wählt ein Fachmann eine geeignete Dicke für die Hartschicht aus. Handelt es sich bei der Hartschicht um einen Hartlack, kann dieser beispielsweise mittels Tauch-, Sprüh- oder Spincoatverfahren auf das Substrat aufgebracht werden. Handelt es sich bei der Hartschicht hingegen um ein anorganisches Material, etwa um ein Material auf Quarzbasis, kann dieses mittels physikalischer oder chemischer Gasphasenabscheidung auf das Substrat aufgebracht werden.

Um die Anhaftung der Hartschicht zu begünstigen, kann das Substrat vorab einer Grundierungsbehandlung unterzogen werden. Auch kann zu diesem Zweck das Substrat mit einer Grundierungsschicht, auch Primerschicht genannt, versehen werden, welche der Haftvermittlung dient. Die Grundierungsschicht, welche gelegentlich auch als Pufferlackschicht bezeichnet wird, kann neben der Haftfestigkeit der Beschichtung auch die Bruchfestigkeit des Brillenglases erhöhen. Das Substrat lässt sich beispielsweise mittels Tauch-, Sprüh- oder Spincoatverfahren mit einer Grundierungsschicht versehen.

Auf das Substrat mit der gegebenenfalls vorhandenen Grundierungsschicht und der gegebenenfalls vorhandenen Hartschicht kann eine Interferenz-/Entspiegelungsschicht aufgebracht sein. Wie die Hartschicht kann auch die Interferenz-/Entspiegelungsschicht einen ein- oder mehrschichtigen Aufbau aufweisen. Einem Fachmann sind derartige ein- oder mehrschichtig aufgebaute Interferenz-/Entspiegelungsschichten bekannt, wobei im Falle einer mehrschichtig aufgebauten Interferenz-/Entspiegelungsschicht die Anzahl der Schichten grundsätzlich nicht weiter eingeschränkt ist. Bei einer mehrschichtig aufgebauten Interferenz-/Entspiegelungsschicht wird die Schichtfolge üblicherweise derart gewählt, dass an eine Schicht mit einem niedrigen Brechungsindex bestimmter Dicke eine Schicht mit einem hohen Brechungsindex bestimmter Dicke angrenzt. In anderen Worten ist es für einen derartigen Aufbau bevorzugt, dass Schichten mit einem niedrigen Brechungsindex und Schichten mit einem hohen Brechungsindex alternierend aufgebracht sind. Entsprechende Materialien und Schichtdicken zur Realisierung eines solchen Aufbaus sind einem Fachmann bekannt. So kann die Interferenz-/Entspiegelungsschicht aus einer Abfolge verschiedener transparenter Materialien, darunter beispielsweise $SiO_2$, SiO, $Ta_2O_5$, $TiO_2$, $ZrO_2$, $Al_2O_3$, $Nd_2O_5$, $Pr_2O_3$, $PrTiO_3$, $La_2O_3$, $Nb_2O_5$, $Y_2O_3$, $HfO_2$, InSn-Oxid (ITO), $Si_3N_4$, MgO, $MgF_2$, $CeO_2$ und ZnS, bestehen, ohne jedoch hierauf beschränkt zu sein. Unter diesen Materialien weisen einige, wie etwa $SiO_2$, einen vergleichsweise niedrigen Brechungsindex auf, während wiederum andere, wie etwa $Ta_2O_5$, einen vergleichsweise hohen Brechungsindex aufweisen. Die jeweiligen Schichten der Interferenz-/Entspiegelungsschicht können ebenfalls mittels physikalischer oder chemischer Gasphasenabscheidung aufgebracht werden. Beispielhafte Verfahren für das Aufbringen mittels physikalischer Gasphasenabscheidung sind

Elektronenstrahlverdampfen aus einem Tiegel, Widerstandsverdampfen aus einem Schiffchen und Plasmaunterstützung während des Verdampfens, ohne jedoch hierauf beschränkt zu sein. Das Substrat kann beim Aufbringen der Interferenz-/Entspiegelungsschicht geheizt werden.

Wie eingangs erwähnt, lässt sich durch Vergüten mit einer Interferenz-/Entspiegelungsschicht eine Reflexminderung erreichen. Grundsätzlich lässt sich das Substrat aber auch derart optisch vergüten, dass es zu einer Reflexerhöhung kommt. Sinngemäß spricht man dann von einer Verspiegelung.

Das erfindungsgemäße Brillenglas weist neben dem Substrat mit der gegebenenfalls darauf vorhandenen Grundierungsschicht, der gegebenenfalls darauf vorhandenen Hartschicht und der gegebenenfalls darauf vorhandenen Interferenz-/Entspiegelungsschicht eine funktionelle Beschichtung auf. Diese ist als äußerste Schicht auf dem Substrat angeordnet. Die Grundierungsschicht, die Hartschicht und die Interferenz-/Entspiegelungsschicht, sofern jeweils vorhanden, sind demnach in der angegebenen Reihenfolge ausgehend von der Oberfläche des Substrats zwischen dem Substrat und der funktionellen Beschichtung angeordnet.

Die funktionelle Beschichtung des erfindungsgemäßen Brillenglases besitzt sowohl oleophobe als auch hydrophobe Eigenschaften, wodurch sie eine Abweisung sowohl von Schmutz als auch von Wassertropfen auf der Oberfläche des Brillenglases ermöglicht. Insofern die funktionelle Beschichtung durch einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80, gekennzeichnet ist, unterliegt sie keinen weiteren besonderen Einschränkungen. Typischerweise ist die funktionelle Beschichtung aus einer Verbindung (1), umfassend einen perfluorierten Kohlenwasserstoffrest, welcher ein oder mehrere etherische Sauerstoffatome aufweist, und weiter umfassend mindestens eine Silylgruppe, welche mit einer oder mit mehreren hydrolysierbaren Gruppen substituiert sein kann, gebildet mit der Maßgabe, dass die Verbindung (1) mindestens zwei hydrolysierbare Gruppen enthält und durch die nachstehende Formel (A) dargestellt ist:

$$\mathrm{Rf} \left[ \mathrm{Y} - \mathrm{X} \right]_{a} \qquad \text{(A)}$$

worin a 1 oder 2 ist, Rf einen Perfluoralkyletherrest, wenn a 1 ist, oder einen Perfluoralkylenetherrest, wenn a 2 ist, bezeichnet, X einen Rest mit mindestens einer Silylgruppe, welche mit einer oder mit mehreren hydrolysierbaren Gruppen substituiert sein kann, bezeichnet und Y einen optionalen Rest, welcher den Perfluoralkyl(en)etherrest Rf und den Rest X miteinander verknüpft, bezeichnet.

Durch das Vorhandensein mindestens zweier hydrolysierbarer Gruppen kann es prinzipiell zu einer zwei- bzw. dreidimensionalen Verknüpfung der Verbindung (1) untereinander sowie mit der Oberfläche des Brillenglases, einer gegebenenfalls darauf aufgebrachten Grundierungsschicht, einer gegebenenfalls darauf aufgebrachten Hartschicht oder einer gegebenenfalls darauf aufgebrachten Interferenz-/Entspiegelungsschicht kommen. Eine zweidimensionale Verknüpfung bedarf einer Verbindung (1) mit zwei hydrolysierbaren Gruppen, während eine dreidimensionale Verknüpfung einer Verbindung (1) mit mindestens drei hydrolysierbaren Gruppen bedarf. Die Verknüpfung der Verbindung (1) erfolgt durch Hydrolysereaktion der hydrolysierbaren Gruppen in der Gegenwart von Wasser, welches in Spuren beim Aufbringen der funktionellen Beschichtung vorhanden ist, gefolgt von einer Kondensationsreaktion, wobei sich schließlich eine Siloxanbindung ausbildet. Allerdings kann in der funktionellen Beschichtung die Verbindung (1) auch als solche vorliegen, d.h. ohne eine Hydrolysereaktion eingegangen zu sein. Demgemäß können in der funktionellen Beschichtung des erfindungsgemäßen Brillenglases noch hydrolysierbare Gruppen vorhanden sein. In anderen Worten ist die funktionelle Beschichtung des erfindungsgemäßen Brillenglases aus der Verbindung (1) gebildet bzw. von dieser abgeleitet.

Es ist bevorzugt, dass die Verbindung (1) mindestens drei hydrolysierbare Gruppen enthält, da es hierdurch, wie vorstehend erwähnt, prinzipiell zu einer dreidimensionalen Verknüpfung der Verbindung (1) kommen kann. Grundsätzlich wird durch eine dreidimensionale Verknüpfung die mechanische Stabilität der funktionellen Beschichtung und damit auch ihre Abriebbeständigkeit bzw. Langlebigkeit erhöht. In Bezug auf eine Obergrenze ist die Anzahl der hydrolysierbaren Gruppen nicht weiter eingeschränkt.

Die hydrolysierbaren Gruppen können jeweils unabhängig voneinander etwa aus einer Alkoxygruppe mit 1 bis 10 Kohlenstoffatomen, beispielsweise einer Methoxygruppe, einer Ethoxygruppe, einer Propoxygruppe oder einer Butoxygruppe, einer Alkoxyalkoxygruppe mit 2 bis 10 Kohlenstoffatomen, beispielsweise einer Methoxymethoxygruppe oder einer Methoxyethoxygruppe, einer Alkenyloxygruppe mit 2 bis 10 Kohlenstoffatomen, beispielsweise einer Isopropenoxygruppe, einer Acyloxygruppe mit 1 bis 10 Kohlenstoffatomen, beispielsweise einer Acetyloxygruppe, einer Aminogruppe oder einem Halogenatom, beispielsweise einem Chloratom, einem Bromatom oder einem Iodatom, ausgewählt sein, ohne jedoch hierauf beschränkt zu sein. Unter diesen hydrolysierbaren Gruppen sind eine Methoxygruppe, eine Ethoxygruppe, eine Isopropenoxygruppe und ein Chloratom bevorzugt.

Handelt es sich bei der hydrolysierbaren Gruppe beispielsweise um ein Halogenatom, wird infolge der Hydrolysereaktion das jeweilige Hydrogenhalogenid freigesetzt. Im Falle einer Alkoxygruppe wird der jeweilige Alkohol freigesetzt. Die hydrolysierbare Gruppe wird somit in ihrer protonierten Form freigesetzt.

In der Verbindung (1) können alle hydrolysierbaren Gruppen identisch sein. Beispielsweise kann es sich bei den hydrolysierbaren Gruppen jeweils um eine Methoxygruppe oder um eine Ethoxygruppe handeln. Auch können in der Verbindung (1) die Silylgruppen vollständig mit hydrolysierbaren Gruppen substituiert sein, so dass die Verbindung (1) beispielsweise Trimethoxysilylgruppen oder Triethoxysilylgruppen aufweist, ohne jedoch hierauf beschränkt zu sein. Liegt keine Substitution mit hydrolysierbaren Gruppen vor oder ist die Substitution unvollständig, enthalten die Silylgruppen typischerweise noch Alkyl- oder Alkenylreste mit 1 bis 3 Kohlenstoffatomen, etwa Methyl, Ethyl, Propyl oder Vinyl, ohne jedoch hierauf beschränkt zu sein.

Was den perfluorierten Kohlenwasserstoffrest anbelangt, unterliegt die Verbindung (1) keinen besonderen Einschränkungen, solange der perfluorierte Kohlenwasserstoffrest ein oder mehrere etherische Sauerstoffatome aufweist. Unter einem etherischen Sauerstoffatom wird vorliegend ein Sauerstoffatom verstanden, welches innerhalb des perfluorierten Kohlenwasserstoffrests eine Etherfunktionalität begründet. In Bezug auf eine Obergrenze ist die Anzahl der etherischen Sauerstoffatome vorliegend nicht weiter eingeschränkt.

Die Anzahl der Kohlenstoffatome im perfluorierten Kohlenwasserstoffrest kann von 2 bis 100, beispielsweise von 2 bis 50, von 5 bis 50, von 5 bis 25 oder von 10 bis 25 betragen, ohne jedoch hierauf beschränkt zu sein. Der perfluorierte Kohlenwasserstoffrest ist gesättigt und enthält demnach keine Kohlenstoff-Kohlenstoff-Mehrfachbindungen. Ebenso ist der perfluorierte Kohlenwasserstoffrest aliphatisch und enthält demnach keine aromatischen Einheiten. Der perfluorierte Kohlenwasserstoffrest kann verzweigt oder unverzweigt sein, wobei eine unverzweigte Struktur bevorzugt ist. Ebenso ist es bevorzugt, dass der perfluorierte Kohlenwasserstoffrest nicht ringförmig ist.

Der perfluorierte Kohlenwasserstoffrest, welcher ein oder mehrere etherische Sauerstoffatome aufweist, kann beispielsweise die Struktureinheit $-(CF_2)_x-O-(CF_2)_y-$umfassen, wobei die Indizes x und y jeweils die Anzahl der Difluormethylen-Einheiten und damit auch die Anzahl der Kohlenstoffatome bezeichnen. An einer oder an beiden der äußeren Difluormethylen-Einheiten hiervon kann jeweils eine Silylgruppe, gegebenenfalls substituiert mit einer oder mit mehreren hydrolysierbaren Gruppen, gebunden sein. Ist an nur eine der beiden äußeren Difluormethylen-Einheiten eine Silylgruppe gebunden, ist an die andere der beiden äußeren Difluormethylen-Einheiten ein Fluoratom gebunden. Zusätzlich dazu kann auch ein Fluoratom der beiden äußeren oder der inneren Difluormethylen-Einheiten durch eine Silylgruppe, gegebenenfalls substituiert mit einer oder mit mehreren hydrolysierbaren Gruppen, ersetzt sein. Ferner kann sich zwischen einer Difluormethylen-Einheit und einer Silylgruppe ein weiterer perfluorierter Kohlenwasserstoffrest der vorstehenden Struktureinheit, welcher die Difluormethylen-Einheit und die Silylgruppe miteinander verknüpft, befinden. An einem solchen perfluorierten Kohlenwasserstoffrest können weitere Silylgruppen, gegebenenfalls substituiert mit einer oder mit mehreren hydrolysierbaren Gruppen, gebunden sein.

Die Verbindung (1) kann noch weitere Struktureinheiten umfassen, sofern die Verbindung (1) einen perfluorierten Kohlenwasserstoffrest, welcher ein oder mehrere etherische Sauerstoffatome aufweist, umfasst und weiter mindestens eine Silylgruppe, welche mit einer oder mit mehreren hydrolysierbaren Gruppen substituiert sein kann, umfasst mit der Maßgabe, dass die Verbindung (1) mindestens zwei hydrolysierbare Gruppen enthält und durch die nachstehende Formel (A) dargestellt ist:

$$\mathrm{Rf}\left[\,\mathrm{Y} - \mathrm{X}\,\right]_a \qquad \text{(A)}$$

Wie bereits vorstehend erwähnt, ist in der Formel (A) a 1 oder 2, bezeichnet Rf einen Perfluoralkyletherrest, wenn a 1 ist, oder einen Perfluoralkylenetherrest, wenn a 2 ist, bezeichnet X einen Rest mit mindestens einer Silylgruppe, welche mit einer oder mit mehreren hydrolysierbaren Gruppen substituiert sein kann, und bezeichnet Y einen optionalen Rest, welcher den Perfluoralkyl(en)etherrest Rf und den Rest X miteinander verknüpft.

Insofern die Verbindung (1) zwingend mindestens zwei hydrolysierbare Gruppen enthält, muss a 2 sein, wenn der Rest X in der Formel (A) lediglich eine Silylgruppe, welche mit einer einzigen hydrolysierbaren Gruppe substituiert ist, enthält.

Wie bereits vorstehend im Zusammenhang mit der Verbindung (1) allgemein ausgeführt, enthält der Perfluoralkyl(en)etherrest Rf keine Kohlenstoff-Kohlenstoff-Mehrfachbindungen sowie keine aromatischen Einheiten. Ansonsten unterliegt der Perfluoralkyl(en)etherrest Rf keinen weiteren Einschränkungen.

Der Rest X in der Formel (A) enthält mindestens eine Silylgruppe, wobei jede Silylgruppe mit einer oder mit mehreren hydrolysierbaren Gruppen substituiert sein kann. In dem Rest X liegen beispielsweise 2 bis 18, bevorzugt 2 bis 9 hydrolysierbare Gruppen vor. Liegen mehr als drei hydrolysierbare Gruppen vor, ist notwendigerweise mehr als eine

Silylgruppe im Rest X vorhanden. Ansonsten gelten in Bezug auf die Silylgruppen und die hydrolysierbaren Gruppen die vorstehenden allgemeinen Ausführungen im Zusammenhang mit der Verbindung (1) entsprechend.

Der optionale Rest Y ist ein zweiwertiger Rest und verknüpft den Perfluoralkyl(en)etherrest Rf und den Rest X miteinander. Der optionale Rest Y, falls vorhanden, weist grundsätzlich keine hydrolysierbaren Gruppen auf. Bei dem optionalen Rest Y kann es sich um einen unsubstituierten oder substituierten Kohlenwasserstoffrest handeln. Der optionale Rest Y kann eine oder mehrere Strukturen, ausgewählt aus der Gruppe, bestehend aus -NR(CO)-, -O(CO)-, -O- und - $SiR_2$-, enthalten, wobei R einen Alkyl- oder Alkenylrest mit 1 bis 3 Kohlenstoffatomen darstellt, etwa Methyl, Ethyl, Propyl oder Vinyl, ohne jedoch hierauf beschränkt zu sein. Beispielsweise kann es sich bei dem optionalen Rest Y um einen Kohlenwasserstoffrest mit insgesamt 2 bis 12 Kohlenstoffatomen handeln, wobei der Kohlenwasserstoffrest eine oder mehrere der vorstehend genannten Strukturen enthalten kann.

Beispiele der Verbindung (1), welche im Einklang mit der Formel (A) sind, beinhalten Trimethoxysilan, Dimethoxysilan, Triethoxysilan, Triisopropenoxysilan, Trichlorsilan und Triaminosilan, wobei jedes dieser Silane einen Perfluoralkyletherrest umfasst. Insbesondere kann es sich bei dem Silan um Trimethoxysilan, welches einen Perfluoralkyletherrest umfasst, handeln.

Die funktionelle Beschichtung ist nicht notwendigerweise aus nur einer einzigen Verbindung (1) gebildet. Sie kann auch aus verschiedenen Verbindungen (1) gebildet sein. Bei der Bildung der funktionellen Beschichtung kann ferner eine Verbindung (2) beteiligt sein, welche sich von der Verbindung (1) lediglich dahingehend unterscheidet, dass die Verbindung (2) nur eine einzige hydrolysierbare Gruppe enthält. Hierdurch lassen sich Endpunkte der zwei- bzw. dreidimensionalen Verknüpfung absättigen, da die Verbindung (2) durch das Vorhandensein von nur einer hydrolysierbaren Gruppe keine zwei- bzw. dreidimensionale Verknüpfung eingehen kann.

Die funktionelle Beschichtung lässt sich mittels geeigneter Aufdampftechniken auf das Substrat mit der gegebenenfalls darauf vorhandenen Grundierungsschicht, der gegebenenfalls darauf vorhandenen Hartschicht und der gegebenenfalls darauf vorhandenen Interferenz-/Entspiegelungsschicht aufbringen, wie weiter unten im Zusammenhang mit dem erfindungsgemäßen Herstellungsverfahren beschrieben.

In Bezug auf die Dicke ist die funktionelle Beschichtung des erfindungsgemäßen Brillenglases nicht weiter eingeschränkt. So kann die Dicke der funktionellen Beschichtung in einem Bereich von 1 nm bis 1000 nm liegen. Bevorzugt liegt die Dicke der funktionellen Beschichtung in einem Bereich von 1 nm bis 100 nm und noch mehr bevorzugt in einem Bereich von 1 nm bis 20 nm. Beispielhaft ist hier ein Wert von etwa 10 nm für die Dicke der funktionellen Beschichtung genannt. Die Dicke der funktionellen Beschichtung, im Folgenden gelegentlich auch als physikalische Schichtdicke der funktionellen Beschichtung bezeichnet, kann beispielsweise durch die Dauer des Verdampfens und die Aufdampfrate eingestellt werden.

Grundsätzlich können die vorstehenden Schichten einseitig oder beidseitig auf das Substrat aufgebracht werden, wobei ein beidseitiges Aufbringen zumindest der funktionellen Beschichtung auf der Vorder- und Rückfläche des Substrats bevorzugt ist.

Aufgrund der funktionellen Beschichtung, welche typischerweise aus der Verbindung (1) gebildet ist mit der Maßgabe, dass die Verbindung (1) mindestens zwei hydrolysierbare Gruppen enthält und durch die vorstehende Formel (A) dargestellt ist, weist die Oberfläche des erfindungsgemäßen Brillenglases einen besonders niedrigen dynamischen Reibungskoeffizienten auf. Dieser kann als ein Maß für die gefühlte Glattheit, mit der die Oberfläche des Brillenglases wahrgenommen wird, aufgefasst werden. Der dynamische Reibungskoeffizient bezieht sich hierbei auf die Reibungskraft, welche zu überwinden ist, um eine Bewegung des Wischgegenstandes auf der Oberfläche des Brillenglases, wie etwa beim Putzen des Brillenglases mit einem Mikrofasertuch oder dergleichen, auszuführen.

Grundsätzlich ist der dynamische Reibungskoeffizient abhängig von der Geschwindigkeit der Wischbewegung. Gelegentlich wird er daher auch als geschwindigkeitsabhängiger dynamischer Reibungskoeffizient bezeichnet. Im Grunde genommen bedeutet dies, dass der dynamische Reibungskoeffizient kontinuierlich bis zur maximalen Geschwindigkeit der Wischbewegung bestimmt werden müsste, um die gefühlte Glattheit messtechnisch exakt abzubilden. Wie von Seiten der Erfinder herausgefunden wurde, lässt sich die messtechnische Abbildung der gefühlten Glattheit jedoch stark vereinfachen, wie nachstehend im Zusammenhang mit dem erfindungsgemäßen Messverfahren zur Bestimmung der Glattheit eines Brillenglases erläutert.

So betrifft die vorliegende Erfindung in einem weiteren Aspekt ein Messverfahren zur Bestimmung der Glattheit eines Brillenglases mit Hilfe eines Rheometers unter Bestimmung dynamischer Reibungskoeffizienten gegenüber einem Mikrofasertuch, welches eine Kreisbahn um die Mitte des Brillenglases beschreibt, wobei die Bestimmung dynamischer Reibungskoeffizienten bei Geschwindigkeiten im Bereich von 0,005 m/s bis 0,4 m/s tangential zur beschriebenen Kreisbahn sowie tangential zur Oberfläche des Brillenglases erfolgt, wobei das erfindungsgemäße Messverfahren dadurch gekennzeichnet ist, dass die Glattheit des Brillenglases durch einen haptischen Glattheitskoeffizienten HGK, berechnet als gewichteter mittlerer dynamischer Reibungskoeffizient aus mindestens zwei mit verschiedenen tangentialen Geschwindigkeiten bestimmten dynamischen Reibungskoeffizienten, ausgedrückt wird.

Im Rahmen der vorliegenden Erfindung beschreibt die Bewegung zur messtechnischen Bestimmung des dynamischen Reibungskoeffizienten eine Kreisbahn um die Mitte des Brillenglases. Die Geschwindigkeit, auf die sich

der dynamische Reibungskoeffizient bezieht, ist tangential zur beschriebenen Kreisbahn sowie tangential zur Oberfläche des Brillenglases. Sie wird daher gelegentlich auch als tangentiale Geschwindigkeit bezeichnet. Als praxisrelevant für die Geschwindigkeit ist hierbei ein Bereich von 0,005 m/s bis 0,4 m/s anzusehen, da das Putzen eines Brillenglases typischerweise mit einer Geschwindigkeit in eben diesem Geschwindigkeitsbereich erfolgt. Wie durch Messungen festgestellt werden konnte, liegt die maximale Geschwindigkeit der Wischbewegung typischerweise bei einem Wert von 0,2 m/s.

Bei der Bestimmung des dynamischen Reibungskoeffizienten wird vorliegend ein Mikrofasertuch des Typs "Savina MX", hergestellt von "kbSeiren", Osaka, Japan, mit den nachstehenden Eigenschaften verwendet:

| | |
|---|---|
| • Faserart: | ultrafeine Mikrofaser "BelimaX" |
| • Zusammensetzung: | 70% Polyester, 30% Nylon |
| • Dicke: | 0,32 mm |
| • flächenbezogene Masse: | 165 g/m$^2$ |
| • längenbezogene Anzahl der Längsfäden: | 78/2,54 cm |
| • längenbezogene Anzahl der Kettfäden: | 81/2,54 cm |

Hierbei wird mit dem Mikrofasertuch in einer rotierenden Bewegung um die Mitte des Brillenglases mit der darauf aufgebrachten funktionellen Beschichtung gewischt. Beim Wischen mit dem Mikrofasertuch muss sichergestellt sein, dass vorab keinerlei reibende Aktion auf der Oberfläche des Brillenglases ausgeführt wurde, welche deren Eigenschaften verändern könnte. Der Andruck des Mikrofasertuchs auf die zu messende Oberfläche des Brillenglases geschieht durch einen elastischen Stempel mit ringförmiger Auflagefläche und beträgt etwa 8380 N/m$^2$. Bei einem Innenradius von 17,5 mm und einem Außenradius von 20,5 mm der ringförmigen Auflagefläche entspricht dies einer Andruckkraft von 3 N. Im Querschnitt betrachtet weist der elastische Stempel eine rechteckige Form mit einer Höhe von 3 mm auf. Der elastische Stempel ist aus Silikon gefertigt und besitzt eine Shore-Härte A von 40.

Im Bereich der ringförmigen Auflagefläche des elastischen Stempels bewegt sich das Mikrofasertuch relativ zur Oberfläche des Brillenglases. Um der Geschwindigkeitsabhängigkeit des dynamischen Reibungskoeffizienten Rechnung zu tragen, wird der dynamische Reibungskoeffizient zweckmäßigerweise in dem vorstehend genannten Geschwindigkeitsbereich von 0,005 m/s bis 0,4 m/s bestimmt, wobei mit der Geschwindigkeit, wie vorstehend erwähnt, die tangentiale Geschwindigkeit gemeint ist. Ausgehend von einem Anfangswert wird die Geschwindigkeit stufenweise erhöht.

Während der rotierenden Bewegung des Mikrofasertuchs wird mit Hilfe eines Rheometers das Drehmoment ermittelt. Dieses ist über den effektiven Radius der ringförmigen Auflagefläche des elastischen Stempels mit der Reibungskraft, welche das Mikrofasertuch für eine gleichförmige Bewegung relativ zur Oberfläche des Brillenglases überwinden muss, wie folgt verknüpft:

$$\text{Drehmoment} = \text{Reibungskraft} \times \text{effektiver Radius} \quad \text{(I)}$$

Der effektive Radius lässt sich mit dem mittleren Radius annähern. Dieser entspricht dem gemittelten Radius der ringförmigen Auflagefläche des elastischen Stempels und lässt sich wie folgt berechnen:

$$\text{mittlerer Radius} = \frac{\text{Außenradius} + \text{Innenradius}}{2} \quad \text{(II)}$$

Der dynamische Reibungskoeffizient, abgekürzt als $\mu_d$, ist mit dem Drehmoment über den effektiven Radius und die Andruckkraft wiederum wie folgt verknüpft:

$$\mu_d = \frac{\text{Drehmoment}}{\text{effektiver Radius} \times \text{Andruckkraft}} = \frac{\text{Reibungskraft}}{\text{Andruckkraft}} \quad \text{(III)}$$

Für jede Geschwindigkeit v ergibt sich ein individuelles Drehmoment(v), bedingt durch eine individuelle Reibungskraft(v), und damit auch ein individueller dynamischer Reibungskoeffizient(v), abgekürzt als $\mu_d$(v):

$$\mu_d(v) = \frac{\text{Drehmoment}(v)}{\text{effektiver Radius} \times \text{Andruckkraft}} = \frac{\text{Reibungskraft}(v)}{\text{Andruckkraft}} \quad \text{(IV)}$$

Um die gefühlte Glattheit messtechnisch abzubilden, ist es entscheidend, wie bei einem Putzhub die Geschwindigkeit v auf den Weg s über die Oberfläche des Brillenglases während der Zeit t verteilt ist. Untersuchungen unter Verwendung einer Kamera mit hoher Bildfrequenz zeigen, dass sich bei einem Putzhub die Geschwindigkeitsverteilung entlang des Wegs, den der Wischgegenstand hierbei zurücklegt, sehr gut mit einer harmonischen Schwingung annähern lässt, wobei der Wischgegenstand an den Umkehrpunkten zum Stillstand kommt. Aufgrund der Symmetrie der Wischbewegung als harmonische Schwingung ist es ausreichend, dass die Geschwindigkeitsverteilung lediglich für einen 1/4-Putzhub betrachtet wird, d.h. von der Mitte des Brillenglases mit der Position s = 0 beim Zeitpunkt t = 0, wo die Wischbewegung ihre Maximalgeschwindigkeit $v_{max}$ erreicht, zum Umkehrpunkt mit der Position $s = s_{max}$ beim Zeitpunkt t = T/4, wo die Wischbewegung zum Stillstand kommt. T bezeichnet hierbei die Dauer eines gesamten Putzhubs, entsprechend einer vollständigen Schwingungsperiode. Für den Weg eines 1/4-Putzhubs als Funktion der Zeit ergibt sich folgender Zusammenhang:

$$s(t) = s_{max} \times \sin(2\pi/T \times t) = s_{max} \times \sin(\omega \times t) \text{ mit } t \in [0; T/4] \quad \text{(V)}$$

Aufgelöst nach der Zeit ergibt sich folgender Ausdruck:

$$t(s) = 1/\omega \times \arcsin(s/s_{max}) \text{ mit } s \in [0; s_{max}] \quad \text{(VI)}$$

Leitet man den Weg nach der Zeit ab, erhält man die Geschwindigkeit als Funktion der Zeit:

$$v(t) = ds(t)/dt = s_{max} \times \cos(\omega \times t) \times \omega = v_{max} \times \cos(\omega \times t) \quad \text{(VII)}$$

Durch Ersetzen der Zeit mit dem vorstehenden Ausdruck erhält man schließlich die Geschwindigkeit als Funktion des Wegs:

$$v(s) = v_{max} \times \cos(\arcsin(s/s_{max})) = v_{max} \times \sqrt{1 - (s/s_{max})^2} \quad \text{(VIII)}$$

Die Geschwindigkeit als Funktion des Wegs ist in Fig. 1 für einen 1/4-Putzhub veranschaulicht. Die Kurve, welche die Geschwindigkeit beschreibt, lässt sich in drei Abschnitte unterteilen. Diese lassen sich wiederum als Balken darstellen, deren Fläche jeweils der Fläche unter dem dazugehörigen Kurvenabschnitt entspricht. Wie sich aus der Darstellung entnehmen lässt, werden 50% des Wegs mit einer mittleren Geschwindigkeit von 95% der maximalen Geschwindigkeit zurückgelegt. Weitere 35% des Wegs werden mit einer mittleren Geschwindigkeit von 72% der maximalen Geschwindigkeit zurückgelegt. Die restlichen 15% des Wegs werden mit einer mittleren Geschwindigkeit von 35% der maximalen Geschwindigkeit zurückgelegt. Basierend auf der Gewichtung der drei Geschwindigkeiten entlang des Wegs (50% des Wegs mit 95% $v_{max}$, 35% des Wegs mit 72% $v_{max}$ und 15% des Wegs mit 35% $v_{max}$) lässt sich ein entsprechend gewichteter mittlerer dynamischer Reibungskoeffizient angeben. Der gewichtete mittlere dynamische Reibungskoeffizient, abgekürzt als $\overline{\mu}_d$, welcher ein Maß für die gefühlte Glattheit ist, ergibt sich dabei wie folgt:

$$\overline{\mu}_d = 0{,}50 \times \mu_d(95\%\ v_{max}) + 0{,}35 \times \mu_d(72\%\ v_{max}) + 0{,}15 \times \mu_d(35\%\ v_{max}) \quad \text{(IX)}$$

Setzt man für $v_{max}$ einen Wert von 0,2 m/s ein, wie er für die maximale Geschwindigkeit der Wischbewegung typisch ist, erhält man für den gewichteten mittleren dynamischen Reibungskoeffizienten:

$$\overline{\mu}_d = 0{,}50 \times \mu_d(0{,}20\ m/s) + 0{,}35 \times \mu_d(0{,}15\ m/s) + 0{,}15 \times \mu_d(0{,}07\ m/s) \quad \text{(X)}$$

Der gewichtete mittlere dynamische Reibungskoeffizient wird, da er ein Maß für die gefühlte Glattheit ist, auch als haptischer Glattheitskoeffizient HGK bezeichnet. Entsprechend gilt:

$$HGK = 0{,}50 \times \mu_d(0{,}20\ m/s) + 0{,}35 \times \mu_d(0{,}15\ m/s) + 0{,}15 \times \mu_d(0{,}07\ m/s) \quad \text{(XI)}$$

Je kleiner der haptische Glattheitskoeffizient HGK, desto größer die gefühlte Glattheit der Oberfläche des Brillenglases. Messtechnisch entspricht der haptische Glattheitskoeffizient also dem gewichteten mittleren dynamischen Reibungskoeffizienten, welcher unter speziellen Parametern, etwa in Bezug auf das verwendete Mikrofasertuch und die

Messgeometrie, wie vorstehend erläutert, ermittelt wird. Überraschenderweise reicht die Bestimmung des dynamischen Reibungskoeffizienten bei drei tangentialen Geschwindigkeiten, nämlich bei 0,20 m/s, 0,15 m/s und 0,07 m/s, bereits aus, um die gefühlte Glattheit messtechnisch ausreichend exakt abzubilden.

Mit dem haptischen Glattheitskoeffizienten HGK lässt sich die gefühlte Glattheit messtechnisch ausreichend exakt abbilden. Die sensorisch mit dem Finger ertastete Glattheit lässt sich messtechnisch noch besser abbilden, wenn man die Beschleunigungsphase in der Nähe des Umkehrpunkts miteinbezieht. Zu diesem Zweck wird zusätzlich ein dynamischer Reibungskoeffizient, welcher bei einer vergleichsweise geringen Geschwindigkeit bestimmt wird, berücksichtigt. Eine sehr gute Vergleichbarkeit zwischen empirischen Versuchen zur Glattheit und der Beschreibung der Glattheit mittels Reibungskurven erzielt man dadurch, wenn man bei einer tangentialen Geschwindigkeit von 0,01 m/s, welche nahe am Stillstand liegt, den dynamischen Reibungskoeffizienten bestimmt und unter Multiplikation mit einem Gewichtungsfaktor von 3 zum haptischen Glattheitskoeffizienten HGK addiert. Der so erhaltene haptische Glattheitskoeffizient R_HGK lautet dann wie folgt:

$$R_HGK = HGK + 3 \times \mu_d(0{,}01\ m/s) \quad (XII)$$

Wie eingangs erwähnt, verleiht die funktionelle Beschichtung dem erfindungsgemäßen Brillenglas einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80.

Das erfindungsgemäße Messverfahren ist grundsätzlich nicht auf die Bestimmung der Glattheit eines Brillenglases beschränkt. Es kann grundsätzlich auf jede Art von beschichteter oder unbeschichteter Oberfläche angewendet werden. Mit Hilfe der beiden haptischen Glattheitskoeffizienten HGK und R_HGK lassen sich beispielsweise verschiedene Oberflächenbeschichtungen unterscheiden und in ihrer Qualität objektiv bewerten. Auf diese Weise können Grenzwerte für unterschiedliche Qualitätsstufen definiert werden.

Wiederum in einem weiteren Aspekt betrifft die vorliegende Erfindung ein Verfahren zur Herstellung eines Brillenglases, insbesondere zur Herstellung des erfindungsgemäßen Brillenglases, umfassend die nachstehenden Schritte (a) bis (f):

(a) Einstellen von Beschichtungsparametern an einer Beschichtungsanlage,
(b) Bereitstellen eines Substrats,
(c) Einsetzen des Substrats in die Beschichtungsanlage,
(d) Versehen des Substrats mit einer funktionellen Beschichtung in der Beschichtungsanlage, wodurch ein Brillenglas, aufweisend ein Substrat und eine als äußerste Schicht auf dem Substrat angeordnete funktionelle Beschichtung, erhalten wird,
(e) Entnehmen des Brillenglases aus der Beschichtungsanlage, und
(f) Bestimmen des haptischen Glattheitskoeffizienten HGK und/oder des haptischen Glattheitskoeffizienten R_HGK in Übereinstimmung mit dem erfindungsgemäßen Messverfahren, wie vorstehend beschrieben.

Mit dem erfindungsgemäßen Herstellungsverfahren, welches im Folgenden unter Bezugnahme auf das Flussdiagramm aus Fig. 2 näher beschrieben wird, kann das erfindungsgemäße Brillenglas, wie vorstehend beschrieben, auf optimierte Weise erhalten werden.

In Schritt (a) des erfindungsgemäßen Herstellungsverfahrens werden Beschichtungsparameter an einer Beschichtungsanlage eingestellt (S100).

Dabei ist die Beschichtungsanlage derart ausgelegt, dass darin mindestens ein Substrat mit einer funktionellen Beschichtung versehen werden kann. Aus Gründen der Wirtschaftlichkeit ist es jedoch bevorzugt, dass in der Beschichtungsanlage eine Vielzahl von Substraten gleichzeitig mit einer funktionellen Beschichtung versehen werden kann, um auf diese Weise Stückkosten zu minimieren. Obgleich im Folgenden von einem Substrat die Rede ist, gelten die nachstehenden Ausführungen gleichermaßen für eine Vielzahl von Substraten.

In Fig. 3 ist eine Beschichtungsanlage 10 mit zugehöriger Steuerungseinheit 2 schematisch dargestellt, wie sie im erfindungsgemäßen Herstellungsverfahren zum Einsatz kommen kann. Die Steuerungseinheit dient der Bedienung der Beschichtungsanlage und damit auch zum Einstellen der Beschichtungsparameter. Typischerweise weist die Steuerungseinheit zumindest eine Recheneinheit 20, eine Speichereinheit 22, eine Kommunikationseinheit 24 und eine Eingabeeinheit 26 auf. In einer bevorzugten Ausführungsform handelt es sich bei der Steuerungseinheit um einen Computer.

Das Einstellen der Beschichtungsparameter an der Beschichtungsanlage erfolgt dergestalt, dass die Beschichtungsanlage in einen Zustand versetzt wird, einen Beschichtungsvorgang durchzuführen, d.h. ein Substrat mit einer funktionellen Beschichtung zu versehen. Über die Steuerungseinheit an der Beschichtungsanlage werden demnach entsprechende Beschichtungsparameter eingestellt, beispielsweise elektrische Stellgrößen, wie etwa elektrische Ströme

und Spannungen zum Betreiben einer Emissionsvorrichtung 12 der Beschichtungsanlage. Die Emissionsvorrichtung ist geeignet, ein Beschichtungsmaterial, das dem Aufbringen der funktionellen Beschichtung auf das Substrat dient, zu verdampfen. Wie in Fig. 3 gezeigt, ist die Emissionsvorrichtung über eine Verbindung 42', die zur Übertragung von Steuerungsbefehlen geeignet ist, mit der Steuerungseinheit verbunden. Die hierbei einzustellenden Werte sind naturgemäß nicht nur von der Art der Emissionsvorrichtung, sondern auch von der Art des verwendeten Beschichtungsmaterials abhängig. Typische Einstellwerte zum Verdampfen eines Beschichtungsmaterials sind dem Fachmann hinreichend bekannt.

Bei der Beschichtungsanlage handelt es sich bevorzugt um eine Vakuumbeschichtungsanlage, worunter verstanden wird, dass das Aufbringen der funktionellen Beschichtung auf das Substrat in einer Vakuumkammer unter Vakuumbedingungen stattfindet. Zudem ist es bevorzugt, dass es sich bei der Emissionsvorrichtung der Beschichtungsanlage um einen thermischer Verdampfer handelt. Durch Anlegen eines elektrischen Stroms wird am ohmschen Widerstand des thermischen Verdampfers thermische Energie freigesetzt, welche das Beschichtungsmaterial verdampfen lässt. Der sich bildende Dampf des Beschichtungsmaterials scheidet sich sodann als Niederschlag im Wesentlichen gleichförmig in der Beschichtungsanlage und damit auch auf dem Substrat ab.

Weitere Beschichtungsparameter, die eingestellt werden können, sind beispielsweise eine Abschaltbedingung. Hierunter wird eine Bedingung verstanden, bei deren Eintreten die Beschichtungsanlage den Beschichtungsvorgang beendet, worunter insbesondere eine Zeitdauer oder auch eine zu erreichende physikalische Schichtdicke der funktionellen Beschichtung verstanden wird.

In Schritt (b) des erfindungsgemäßen Herstellungsverfahrens wird ein Substrat bereitgestellt (S102). Wie bereits vorstehend näher ausgeführt, unterliegt das Substrat als solches keinen besonderen Einschränkungen. Die vorstehenden Ausführungen, wie sie diesbezüglich im Zusammenhang mit dem erfindungsgemäßen Brillenglas getroffen worden sind, gelten für das erfindungsgemäße Herstellungsverfahren somit entsprechend.

Der Vollständigkeit halber sei angemerkt, dass Schritt (b) auch vor Schritt (a) durchgeführt werden kann.

In Schritt (c) des erfindungsgemäßen Herstellungsverfahrens wird das Substrat in die Beschichtungsanlage eingesetzt (S104). Beispielsweise kann das mit einer funktionellen Beschichtung zu versehende Substrat mit dafür vorgesehenen Halteelementen einer Haltevorrichtung 18 in der Beschichtungsanlage positioniert werden. Wie in Fig. 3 gezeigt, kann eine Vielzahl von mit einer funktionellen Beschichtung zu versehenden Substraten 30 auf der Haltevorrichtung der Beschichtungsanlage angeordnet sein.

Bevor das Substrat in die Beschichtungsanlage eingesetzt wird, können eine Grundierungsschicht, eine Hartschicht und eine Interferenz-/Entspiegelungsschicht in der angegebenen Reihenfolge auf das Substrat aufgebracht werden. Auch hier gelten die vorstehenden Ausführungen, wie sie diesbezüglich im Zusammenhang mit dem erfindungsgemäßen Brillenglas getroffen worden sind, entsprechend.

Während das Aufbringen der Hartschicht beispielsweise mittels Tauch-, Sprüh- oder Spincoatverfahren in einer eigens dafür vorgesehenen Vorrichtung erfolgt, kann das Aufbringen der Interferenz-/Entspiegelungsschicht in der Beschichtungsanlage, wie sie für das Aufbringen der funktionellen Beschichtung auf das Substrat zum Einsatz kommt, erfolgen.

In Schritt (d) des erfindungsgemäßen Herstellungsverfahrens wird das Substrat mit einer funktionellen Beschichtung in der Beschichtungsanlage versehen, wodurch ein Brillenglas, aufweisend ein Substrat und eine als äußerste Schicht auf dem Substrat angeordnete funktionelle Beschichtung, erhalten wird (S106). Wie bereits vorstehend erwähnt, handelt es sich bei der Beschichtungsanlage bevorzugt um eine Vakuumbeschichtungsanlage. Das Aufbringen der funktionellen Beschichtung findet demnach bevorzugt in einer Vakuumkammer unter Vakuumbedingungen statt, wobei sich das Beschichtungsmaterial als Dampfniederschlag unter Ausbildung der funktionellen Beschichtung auf dem Substrat abscheidet. Der während des Beschichtungsvorgangs in der Vakuumkammer vorherrschende Druck beträgt typischerweise weniger als $10^{-2}$ mbar.

In einer bevorzugten Ausführungsform weist die Beschichtungsanlage eine Abdeckvorrichtung 14, auch Shutter genannt, auf, um bei Bedarf den Materialstrom des Beschichtungsmaterials ausgehend von der Emissionsvorrichtung zu dem auf der Haltevorrichtung angeordneten Substrat zu unterbrechen. Vorteilhafterweise kann auf diese Weise mit minimaler zeitlicher Verzögerung der Beschichtungsvorgang beendet werden, wenn die zu erreichende physikalische Schichtdicke der funktionellen Beschichtung erreicht worden ist. Im Gegensatz dazu würde ein Verringern der thermischen Energiezufuhr, beispielsweise durch Verringern des am thermischen Verdampfer anliegenden elektrischen Stroms, eine größere zeitliche Verzögerung bedeuten, da jener elektrische Strom entsprechend weit herunterregelt werden müsste, so dass kein Verdampfen des Beschichtungsmaterials mehr erfolgen kann, wobei während des Herunterregelns weiterhin Beschichtungsmaterial verdampft.

Wie in Fig. 3 gezeigt, ist die Abdeckvorrichtung mittels einer Verbindung 42, die zur Übertragung von Steuerungsbefehlen geeignet ist, mit der Steuerungseinheit verbunden. Es ist bevorzugt, dass die Beschichtungsanlage zusätzlich einen Messsensor 16 aufweist, welcher mittels einer Verbindung 40, die zur Übertragung von Messdaten geeignet ist, mit der Steuerungseinheit verbunden ist. Die Verbindungen 40, 42, 42' können wahlweise kabelgebunden oder vorteilhafterweise drahtlos ausgestaltet sein.

In einer bevorzugten Ausführungsform ist der Messsensor ein Schwingquarz. Über die Änderung seiner Eigenfrequenz lässt sich bei bekannter Fläche des Schwingquarzes der Massezuwachs der funktionellen Beschichtung unter Berücksichtigung der Dichte hiervon in eine physikalische Schichtdicke umrechnen. Auf diese Weise kann der durch den Dampfniederschlag bedingte Zuwachs der physikalischen Schichtdicke überwacht werden. Sobald die zu erreichende physikalische Schichtdicke als Abschaltbedingung erreicht worden ist, wird der Beschichtungsvorgang mit Hilfe der Abdeckvorrichtung beendet, was typischerweise durch Abschatten der Emissionsvorrichtung geschieht.

Alternativ sind auch Ausführungsformen denkbar, bei denen der Messsensor lediglich die fortlaufende Dauer der Beschichtung überwacht und nach Verstreichen einer zuvor in den Beschichtungsparametern eingestellten Zeitdauer als Abschaltbedingung den Beschichtungsvorgang beendet. In einem solchen Fall kann auf den Messsensor auch gänzlich verzichtet werden.

Zum Erhalten eines Brillenglases, aufweisend ein Substrat und eine als äußerste Schicht auf dem Substrat angeordnete funktionelle Beschichtung, ist es bevorzugt, dass in Schritt (d) das Versehen des Substrats mit einer funktionellen Beschichtung in der Beschichtungsanlage unter Verwendung einer die Verbindung (1) enthaltenden Quelle durch Verdampfen erfolgt. Hierbei wird die als Beschichtungsmaterial dienende Verbindung (1), gegebenenfalls zusammen mit einer weiteren Verbindung, etwa der Verbindung (2), verdampft. Der so entstehende Dampf aus der Verbindung (1) und gegebenenfalls weiteren Verbindungen bewegt sich in Richtung des Substrats und scheidet sich auf der Oberfläche des Substrats durch Kondensieren unter Bildung der funktionelle Beschichtung ab. Man spricht sinngemäß auch von einem Aufdampfen der Verbindung (1). Der Einfachheit halber wird hier lediglich auf die Verbindung (1) Bezug genommen, was jedoch die Anwesenheit einer weiteren Verbindung, etwa der Verbindung (2), nicht ausschließen soll.

Das Aufdampfen ist eine hochvakuumbasierte Beschichtungstechnik und zählt zu den Verfahren der physikalischen Gasphasenabscheidung. Typische Prozessdrücke liegen in einem Bereich von $10^{-7}$ bis $10^{-4}$ mbar. Das zu verdampfende Ausgangsmaterial wird hierbei auf Temperaturen nahe am Siedepunkt erhitzt. Durch die Anwesenheit von Wasser in der Vakuumkammer, welches in geringen Mengen beim Beschichten oder danach vorhanden ist, kann es zu einer Hydrolysereaktion der hydrolysierbaren Gruppen, gefolgt von einer Kondensationsreaktion, kommen, wodurch es prinzipiell zur Ausbildung einer zwei- bzw. dreidimensionalen Verknüpfung der aufgedampften Verbindung (1) kommen kann.

Bei der die Verbindung (1) enthaltenden Quelle handelt es sich vorzugsweise um eine Tablette oder Pille, welche die Verbindung (1) in gebundener Form enthält. Vorliegend verwendbare Tabletten können beispielsweise aus einem keramischen Grundkörper, welcher ein hohes Oberflächen-zu-Volumen-Verhältnis aufweist, gebildet sein. Vorliegend verwendbare Pillen können beispielsweise aus Kupfertiegeln, welche mit Stahlwolle gefüllt sind, gebildet sein. Der keramische Grundkörper bzw. die Stahlwolle ist dabei mit dem zu verdampfenden Ausgangsmaterial getränkt. Entsprechende Tabletten oder Pillen sind kommerziell erhältlich. Durch Einlegen einer solchen Pille oder Tablette in eine dafür vorgesehene Aufnahme der Emissionsvorrichtung kann das Beschichtungsmaterial durch die thermische Energiezufuhr zum Verdampfen gebracht werden, welches sich dann als Dampfniederschlag auf der Oberfläche des Substrats abscheidet.

Bei Bedarf kann die zu beschichtende Oberfläche des Substrats vorab einer Plasmabehandlung unterzogen werden.

Die Temperatur während des Verdampfens wird so gewählt, dass es einerseits zu einer ausreichenden Freisetzung des zu verdampfenden Beschichtungsmaterials kommt, andererseits jedoch nicht zu dessen Zersetzung. Das Verdampfen erfolgt typischerweise mit einer Verdampfungsrate in einem Bereich von 0,05 nm/s bis 3 nm/s, wobei für die maximale Verdampfungsrate ein Bereich von 0,1 nm/s bis 1 nm/s bevorzugt ist und ein Bereich von 0,25 nm/s bis 0,45 nm/s noch mehr bevorzugt ist. Unter der Verdampfungsrate wird die Rate verstanden, mit der das Beschichtungsmaterial auf das Substrat aufgedampft wird, weswegen sie auch als Aufdampfrate bezeichnet wird. Die Aufdampfrate hängt unter anderem von der Verdampfungstemperatur des Beschichtungsmaterials ab. Zusammen mit der Dauer des Verdampfens lässt sich durch die Wahl der Verdampfungsrate die physikalische Schichtdicke der auf das Substrat aufzubringenden funktionellen Beschichtung einstellen.

Wie bereits vorstehend erwähnt, erfolgt das Verdampfen vorzugsweise mit Hilfe eines thermischen Verdampfers, beispielsweise mit Hilfe eines Widerstandsverdampfers. Der dafür notwendige Energieeintrag geschieht hierbei durch Erhitzen der Aufnahme der Emissionsvorrichtung, bei der es sich beispielsweise um einen Materialbehälter handelt. In diesem kann sich die Tablette oder Pille, welche die Verbindung (1) in gebundener Form enthält, befinden. Bei dem Materialbehälter kann es sich um ein Schiffchen aus Molybdän, Wolfram oder Tantal, aber auch um ein Schiffchen aus keramischen Materialien handeln. Typischerweise liegt der Schiffchenstrom in einem Bereich von 0,1 A bis 10 A, wobei ein Bereich von 1,0 A bis 7,0 A bevorzugt ist und ein Bereich von 3,0 A bis 6,0 A noch mehr bevorzugt ist. Der thermische Verdampfer wird mit einer Wechselspannung von 230 V betrieben. Die theoretische Leistungsaufnahme des thermischen Verdampfers lässt sich wie folgt berechnen:

$$\text{theoretische Leistungsaufnahme} = \sqrt{2} \times 230\ \text{V} \times \text{Schiffchenstrom} \qquad \text{(XIII)}$$

Alternativ kann das Verdampfen auch mittels Elektronenstrahlen, Lichtbogen oder Laser erfolgen.

In Schritt (e) des erfindungsgemäßen Herstellungsverfahrens wird das Brillenglas aus der Beschichtungsanlage entnommen (S108). Sofern der Beschichtungsvorgang in einer Vakuumkammer stattgefunden hat, wird die Beschichtungsanlage zunächst auf atmosphärische Druckverhältnisse gebracht, was zum Beispiel durch Einleiten eines Inertgases erfolgen kann.

In Schritt (f) des erfindungsgemäßen Herstellungsverfahrens wird bzw. werden der haptische Glattheitskoeffizient HGK und/oder der haptische Glattheitskoeffizient R_HGK bestimmt (S110). Dies geschieht in Übereinstimmung mit dem erfindungsgemäßen Messverfahren, wie vorstehend beschrieben.

Die auf das Substrat aufgebrachte funktionelle Beschichtung bedarf keiner speziellen Nachbearbeitung. Das mit dem erfindungsgemäßen Herstellungsverfahren erhältliche Brillenglas kann somit unmittelbar für die Brillenfertigung eingesetzt werden.

Bei Bedarf kann jedoch das erfindungsgemäße Herstellungsverfahren, nach Schritt (f), den nachstehenden Schritt (g) umfassen:

(g) Ermitteln einer Abweichung des haptischen Glattheitskoeffizienten HGK und/oder des haptischen Glattheitskoeffizienten R_HGK von einem vorab festgelegten Soll-Wert, um auf Basis der ermittelten Abweichung gegebenenfalls die Beschichtungsparameter in Schritt (a) anzupassen (S112).

Ein Soll-Wert des haptischen Glattheitskoeffizienten HGK und/oder des haptischen Glattheitskoeffizienten R_HGK lässt sich vorab abhängig von der gewünschten Qualitätsstufe festlegen. Der in Schritt (f) erhaltene Ist-Wert für die Glattheit des Brillenglases, ausgedrückt durch den haptischen Glattheitskoeffizienten HGK und/oder den haptischen Glattheitskoeffizienten R_HGK, lässt sich sodann mit dem vorab festgelegten Soll-Wert vergleichen. Anschließend wird auf Basis der ermittelten Abweichung überprüft, ob die Qualitätsanforderungen an die Glattheit des Brillenglases erfüllt sind oder nicht. Ist die ermittelte Abweichung zu groß, d.h. sind die Qualitätsanforderungen nicht erfüllt, erfolgt eine Anpassung der Beschichtungsparameter mit dem Ziel, die Abweichung in dem darauffolgenden Verfahrenszyklus zu verringern, so dass das in dem darauffolgenden Verfahrenszyklus erhaltene Brillenglas den Qualitätsanforderungen genügt. Vorzugsweise wird unter einer solchen Anpassung der Beschichtungsparameter eine Anpassung der Abschaltbedingung, insbesondere eine Anpassung der zu erreichenden physikalischen Schichtdicke der funktionellen Beschichtung, verstanden.

Wie dem Fachmann bekannt ist, nimmt mit zunehmender physikalischer Schichtdicke der funktionellen Beschichtung die Glattheit des Brillenglases zu. Durch die Wahl der physikalischen Schichtdicke als Abschaltbedingung lässt sich demnach die Glattheit des Brillenglases steuern. Allerdings lassen sich auch andere Beschichtungsparameter anpassen, um einer zu großen Abweichung, sofern gegeben, Rechnung zu tragen. So ist es grundsätzlich auch denkbar, dass im Falle eines thermischen Verdampfers als Emissionsvorrichtung der am thermischen Verdampfer anliegende elektrische Strom entsprechend angepasst wird.

Die Anpassung der Beschichtungsparameter stellt eine Optimierungsschleife dar. Ausgehend von der ermittelten Abweichung werden die Beschichtungsparameter mit dem Ziel angepasst, eine gewünschte Qualitätsstufe in dem darauffolgenden Verfahrenszyklus zu erreichen. Im optimalen Fall ist die ermittelte Abweichung in dem darauffolgenden Verfahrenszyklus derart gering, dass keine weitere Anpassung der Beschichtungsparameter mehr erforderlich ist.

Die vorliegende Erfindung erlaubt die Bereitstellung eines Brillenglases mit verminderten Reibungseigenschaften. Erreicht wird dies durch eine funktionelle Beschichtung, welche einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80, aufweist, wobei zur Bestimmung der haptischen Glattheitskoeffizienten HGK und R_HGK das erfindungsgemäße Messverfahren zur Bestimmung der Glattheit eines Brillenglases herangezogen werden kann.

Aufgrund der oleophoben und hydrophoben Eigenschaften der funktionellen Beschichtung weist das erfindungsgemäße Brillenglas, welches mit dem erfindungsgemäßen Herstellungsverfahren erhalten werden kann, zudem eine ausgezeichnete Schmutz- und Wasserabweisung und damit insgesamt eine ausgezeichnete Reinig- und Handhabbarkeit auf.

## Figurenbeschreibung

Fig. 1 zeigt eine graphische Darstellung des Zusammenhangs zwischen Geschwindigkeit und Weg bei der Wischbewegung über ein Brillenglas für einen 1/4-Putzhub. Im Vergleich zur Kurve auf der linken Seite sind bei der Kurve auf der rechten Seite zusätzlich drei Balken eingefügt, deren Fläche jeweils der Fläche unter dem dazugehörigen Kurvenabschnitt entspricht.

Fig. 2 zeigt das erfindungsgemäße Herstellungsverfahren in Form eines Flussdiagramms.

Fig. 3 zeigt eine schematische Darstellung einer Beschichtungsanlage mit zugehöriger Steuerungseinheit zum Versehen eines Substrats mit einer funktionellen Beschichtung, wie sie im erfindungsgemäßen Herstellungsverfahren zum Einsatz kommen kann.

Fig. 4 zeigt den dynamischen Reibungskoeffizienten in Abhängigkeit der Wischgeschwindigkeit für die beschichteten Kunststoffbrillengläser aus dem Ausführungsbeispiel sowie aus dem Vergleichsbeispiel. Die Kurven sind durch Bestimmung der dynamischen Reibungskoeffizienten bei tangentialen Geschwindigkeiten von 0,0002 m/s, 0,002 m/s, 0,01 m/s, 0,03 m/s, 0,07 m/s, 0,15 m/s, 0,20 m/s und 0,40 m/s sowie anschließende Interpolation anhand der bei diesen Geschwindigkeiten bestimmten dynamischen Reibungskoeffizienten erhalten worden. Die für die Berechnung relevanten Stellen (0,01 m/s, 0,07 m/s, 0,15 m/s und 0,20 m/s) sind durch Markierungen gekennzeichnet.

**Beispiele**

Das nachstehende Ausführungsbeispiel dient der weiteren Erläuterung der vorliegenden Erfindung, ohne jedoch hierauf beschränkt zu sein.

Als Substrat für die Beschichtung diente ein rohrundes Kunststoffbrillenglas mit den nachstehenden Eigenschaften:

| | |
|---|---|
| • Durchmesser: | 60 mm |
| • Brechungsindex: | 1,60 |
| • Brechkraft (sphärische Wirkung): | -2,25 dpt |

Mit Hilfe eines Tauchverfahrens wurde zunächst eine Hartschicht auf das Substrat aufgebracht. Auf dieses wurde wiederum mit Hilfe eines ionengestützten physikalischen Gasphasenabscheidungsverfahrens eine Interferenz-/Entspiegelungsschicht aufgebracht. Nach Aufbringen der letzten Schicht der Interferenz-/Entspiegelungsschicht wurde die Oberfläche einer Plasmabehandlung unterzogen, bevor hierauf die funktionelle Beschichtung aufgedampft wurde. Zu diesem Zweck wurde eine Pille des Typs "Surfclear 100M", welche ein Beschichtungsmaterial im Einklang mit Formel (A) in gebundener Form enthielt, in einer Vakuumbeschichtungsanlage per Widerstandsverdampfer mit einem Schiffchenstrom von 5,4 A erhitzt. Dabei bildete sich eine funktionelle Beschichtung mit einer Dicke von 9 nm auf der Interferenz-/Entspiegelungsschicht aus. Die maximale Aufdampfrate betrug 0,44 nm/s bei einer Beschichtungszeit von 50 Sekunden. Nach dem Aufbringen der funktionellen Beschichtung wurde der Beschichtungsvorgang beendet und die Vakuumbeschichtungsanlage wurde belüftet.

Das so erhaltene Brillenglas wurde nach der Beschichtung keiner weiteren Behandlung unterworfen, insbesondere keiner reibenden Aktion ausgesetzt, die über eine übliche Reinigung durch Wischen hinausgeht.

Anschließend wurde das Brillenglas in Übereinstimmung mit dem erfindungsgemäßen Messverfahren hinsichtlich seiner Glattheit vermessen. Zu diesem Zweck wurde das Brillenglas zunächst mittels einer Halterung in einem Rheometer des Typs "Haake Mars iQ Air" mittig auf der unteren Auflage der Messvorrichtung fixiert, sodass die funktionelle Beschichtung, welche auf der konvexen Seite des Substrats aufgebracht war, in Richtung des Rotors der Messvorrichtung zeigte. Die Mitte des Brillenglases kam dabei genau unter der Mitte des Rotors zu liegen. Auf die Oberfläche des Brillenglases wurde sodann ein Mikrofasertuch des Typs "Savina MX", hergestellt von "kbSeiren", Osaka, Japan, mit Abmessungen von 45 mm × 45 mm platziert. Der Rotor der Messvorrichtung war so ausgelegt, dass sich an dessen unterem Ende eine kreisförmige Platte befand, auf der wiederum mittig ein Silikonring mit einem Innenradius von 17,5 mm, einem Außenradius von 20,5 mm und einer Höhe von 3 mm angebracht war. Der Silikonring besaß eine Shore-Härte A von 40.

Zur Messung des dynamischen Reibungskoeffizienten wurde der Rotor auf die konvexe Seite des Brillenglases abgesenkt. Mit Hilfe des Silikonrings des Rotors wurde das Mikrofasertuch mit einer Andruckkraft von 3 N senkrecht auf die Oberfläche des Brillenglases gedrückt. Durch Rotieren des Rotors wurde das Mikrofasertuch relativ zur Oberfläche des Brillenglases für eine bestimmte Zeitdauer, die vier Umläufen des Mikrofasertuchs auf der Oberfläche des Brillenglases entsprach, gleichmäßig bewegt, wobei dies mit einer Geschwindigkeit von 0,01 m/s tangential zum Außenradius des Silikonrings erfolgte. Durch die Messvorrichtung wurde zeitgleich das Drehmoment, welches zur Bewegung des Mikrofasertuchs relativ zur Oberfläche des Brillenglases erforderlich war, ermittelt. Hieraus ließ sich schließlich der dynamische Reibungskoeffizient für die tangentiale Geschwindigkeit von 0,01 m/s bestimmen. Die Bestimmung des dynamischen Reibungskoeffizienten für die tangentialen Geschwindigkeiten von 0,07 m/s, 0,15 m/s und 0,20 m/s erfolgte analog hierzu. Dabei wurde die Anzahl der Umläufe an die jeweilige Geschwindigkeit unter Berücksichtigung einer Beschleunigungsphase zum Erreichen einer gleichmäßigen Geschwindigkeit angepasst und betrug zwischen vier und acht Umläufen.

Aus den so bestimmten dynamischen Reibungskoeffizienten ergaben sich ein HGK von 0,287 gemäß Formel

(XI) und ein R_HGK von 0,614 gemäß Formel (XII).

Um eine höhere Qualitätsstufe in dem darauffolgenden Verfahrenszyklus zu erreichen, insbesondere im Hinblick auf den HGK von 0,287, wurde eine Anpassung der Beschichtungsparameter vorgenommen. Im vorliegenden Fall wurden die Beschichtungsparameter dahingehend angepasst, dass als Abschaltbedingung eine zu erreichende physikalische Schichtdicke der funktionellen Beschichtung von 13 nm mit einer maximalen Aufdampfrate von 0,43 nm/s bei einer Beschichtungszeit von 68 Sekunden eingestellt wurde.

Anschließend wurde unter den angepassten Beschichtungsparametern ein identisches Substrat in der Vakuumbeschichtungsanlage mit einer funktionellen Beschichtung versehen. Die dynamischen Reibungskoeffizienten wurden wie zuvor bestimmt.

Aus den so bestimmten dynamischen Reibungskoeffizienten ergaben sich ein HGK von 0,24 gemäß Formel (XI) und ein R_HGK von 0,50 gemäß Formel (XII).

Durch die vorgenommene Anpassung der Beschichtungsparameter konnten die haptischen Glattheitskoeffizienten HGK und R_HGK verringert werden. Entsprechend wies das aus diesem Verfahrenszyklus erhaltene Brillenglas eine verbesserte Glattheit auf.

Als Vergleichsbeispiel wurde ein handelsübliches Brillenglas, welches bezüglich seines Substrats baugleich zu dem Kunststoffbrillenglas aus dem Ausführungsbeispiel war, jedoch nicht mit einer entsprechenden funktionellen Beschichtung versehen war, verwendet.

Auch hier erfolgte die Messung der dynamischen Reibungskoeffizienten bei tangentialen Geschwindigkeiten von 0,01 m/s, 0,07 m/s, 0,15 m/s und 0,20 m/s, wie im Zusammenhang mit dem Ausführungsbeispiel beschrieben.

Aus den so bestimmten dynamischen Reibungskoeffizienten ergaben sich ein HGK von 0,473 gemäß Formel (XI) und ein R_HGK von 1,77 gemäß Formel (XII).

Das Brillenglas aus dem Vergleichsbeispiel genügte damit nicht den Qualitätsanforderungen in Bezug auf die Glattheit.

Wie sich Fig. 4 entnehmen lässt, ist der geschwindigkeitsabhängige dynamische Reibungskoeffizient im Falle der beschichteten Kunststoffbrillengläser aus dem Ausführungsbeispiel vergleichsweise niedrig. Mit zunehmender tangentialer Geschwindigkeit lässt sich nur ein geringfügiger Anstieg des dynamischen Reibungskoeffizienten beobachten. Somit erlaubt das erfindungsgemäße Brillenglas ein besonders leichtgängiges Wischen mit geringem Kraftaufwand. Demgegenüber ist bei dem Brillenglas aus dem Vergleichsbeispiel der dynamische Reibungskoeffizient deutlich erhöht.

Bezugszeichenliste:

| | |
|---|---|
| 2 | Steuerungseinheit |
| 10 | Beschichtungsanlage |
| 12 | Emissionsvorrichtung |
| 14 | Abdeckvorrichtung |
| 16 | Messsensor |
| 18 | Haltevorrichtung |
| 20 | Recheneinheit |
| 22 | Speichereinheit |
| 24 | Kommunikationseinheit |
| 26 | Eingabeeinheit |
| 30 | Substrat |
| 40, 42, 42' | Verbindung |
| S100 | Schritt (a) |
| S102 | Schritt (b) |
| S104 | Schritt (c) |
| S106 | Schritt (d) |
| S108 | Schritt (e) |
| S110 | Schritt (f) |
| S112 | Schritt (g) |

Weiterhin betrifft die vorliegende Erfindung folgende Punkte 1 bis 17:

1. Messverfahren zur Bestimmung der Glattheit eines Brillenglases mit Hilfe eines Rheometers unter Bestimmung dynamischer Reibungskoeffizienten gegenüber einem Mikrofasertuch, welches eine Kreisbahn um die Mitte des Brillenglases beschreibt, wobei die Bestimmung dynamischer Reibungskoeffizienten bei Geschwindigkeiten im

Bereich von 0,005 m/s bis 0,4 m/s tangential zur beschriebenen Kreisbahn sowie tangential zur Oberfläche des Brillenglases erfolgt,
dadurch gekennzeichnet, dass die Glattheit des Brillenglases durch einen haptischen Glattheitskoeffizienten HGK, berechnet als gewichteter mittlerer dynamischer Reibungskoeffizient aus mindestens zwei mit verschiedenen tangentialen Geschwindigkeiten bestimmten dynamischen Reibungskoeffizienten, ausgedrückt wird.

2. Messverfahren nach Punkt 1, wobei dynamische Reibungskoeffizienten, welche bei tangentialen Geschwindigkeiten von 0,20 m/s, 0,15 m/s und 0,07 m/s bestimmt werden, Eingang in die Berechnung des haptischen Glattheitskoeffizienten HGK finden.

3. Messverfahren nach Punkt 2, wobei der haptische Glattheitskoeffizient HGK anhand der nachstehenden Formel (XI) berechnet wird:

$$\mathrm{HGK} = 0{,}50 \times \mu_d(0{,}20\ \mathrm{m/s}) + 0{,}35 \times \mu_d(0{,}15\ \mathrm{m/s}) + 0{,}15 \times \mu_d(0{,}07\ \mathrm{m/s}) \quad \mathrm{(XI)}$$

worin $\mu_d(0{,}20\ \mathrm{m/s})$ der bei einer tangentialen Geschwindigkeit von 0,20 m/s bestimmte dynamische Reibungskoeffizient ist, $\mu_d(0{,}15\ \mathrm{m/s})$ der bei einer tangentialen Geschwindigkeit von 0,15 m/s bestimmte dynamische Reibungskoeffizient ist und $\mu_d(0{,}07\ \mathrm{m/s})$ der bei einer tangentialen Geschwindigkeit von 0,07 m/s bestimmte dynamische Reibungskoeffizient ist.

4. Messverfahren nach Punkt 3, wobei zusätzlich der dynamische Reibungskoeffizient bei einer tangentialen Geschwindigkeit von 0,01 m/s bestimmt wird und dieser Eingang in die Berechnung eines haptischen Glattheitskoeffizienten R_HGK anhand der nachstehenden Formel (XII) findet:

$$\mathrm{R_HGK} = \mathrm{HGK} + 3 \times \mu_d(0{,}01\ \mathrm{m/s}) \quad \mathrm{(XII)}$$

worin $\mu_d(0{,}01\ \mathrm{m/s})$ der bei einer tangentialen Geschwindigkeit von 0,01 m/s bestimmte dynamische Reibungskoeffizient ist.

5. Brillenglas, aufweisend ein Substrat und eine als äußerste Schicht auf dem Substrat angeordnete funktionelle Beschichtung,
dadurch gekennzeichnet, dass die funktionelle Beschichtung dem Brillenglas einen haptischen Glattheitskoeffizienten HGK von höchstens 0,28, bevorzugt von höchstens 0,25, bestimmt in Übereinstimmung mit dem Messverfahren nach Punkt 3, und/oder einen haptischen Glattheitskoeffizienten R_HGK von höchstens 0,85, bevorzugt von höchstens 0,80, bestimmt in Übereinstimmung mit dem Messverfahren nach Punkt 4, verleiht.

6. Brillenglas nach Punkt 5, wobei die funktionelle Beschichtung aus einer Verbindung (1), umfassend einen perfluorierten Kohlenwasserstoffrest, welcher ein oder mehrere etherische Sauerstoffatome aufweist, und weiter umfassend mindestens eine Silylgruppe, welche mit einer oder mit mehreren hydrolysierbaren Gruppen substituiert sein kann, gebildet ist mit der Maßgabe, dass die Verbindung (1) mindestens zwei hydrolysierbare Gruppen enthält und durch die nachstehende Formel (A) dargestellt ist:

$$\mathrm{Rf}\left[\mathrm{Y} - \mathrm{X}\right]_a \quad \mathrm{(A)}$$

worin a 1 oder 2 ist, Rf einen Perfluoralkyletherrest, wenn a 1 ist, oder einen Perfluoralkylenetherrest, wenn a 2 ist, bezeichnet, X einen Rest mit mindestens einer Silylgruppe, welche mit einer oder mit mehreren hydrolysierbaren Gruppen substituiert sein kann, bezeichnet und Y einen optionalen Rest, welcher den Perfluoralkyl(en)etherrest Rf und den Rest X miteinander verknüpft, bezeichnet.

7. Brillenglas nach Punkt 6, wobei die hydrolysierbaren Gruppen jeweils unabhängig voneinander aus der Gruppe, bestehend aus einer Alkoxygruppe mit 1 bis 10 Kohlenstoffatomen, einer Alkoxyalkoxygruppe mit 2 bis 10 Kohlenstoffatomen, einer Alkenyloxygruppe mit 2 bis 10 Kohlenstoffatomen, einer Acyloxygruppe mit 1 bis 10 Kohlenstoffatomen, einer Aminogruppe und einem Halogenatom, ausgewählt sind.

8. Brillenglas nach Punkt 6 oder 7, wobei die hydrolysierbaren Gruppen jeweils unabhängig voneinander aus der Gruppe, bestehend aus einer Methoxygruppe, einer Ethoxygruppe, einer Isopropenoxygruppe und einem Chloratom, ausgewählt sind.

9. Brillenglas nach einem der Punkte 6 bis 8, wobei die durch die Formel (A) dargestellte Verbindung (1) Trimethoxysilan, welches einen Perfluoralkyletherrest umfasst, ist.

10. Brillenglas nach einem der Punkte 5 bis 9, wobei die Dicke der funktionellen Beschichtung in einem Bereich von 1 nm bis 100 nm liegt.

11. Brillenglas nach einem der Punkte 5 bis 10, wobei zwischen dem Substrat und der als äußerste Schicht auf dem Substrat angeordneten funktionellen Beschichtung ausgehend von der Oberfläche des Substrats mindestens eine weitere Schicht, ausgewählt aus der Gruppe, bestehend aus einer Grundierungsschicht, einer Hartschicht und einer Interferenz-/Entspiegelungsschicht, in der angegebenen Reihenfolge angeordnet ist.

12. Verfahren zur Herstellung eines Brillenglases, insbesondere zur Herstellung des Brillenglases nach einem der Punkte 5 bis 11, umfassend die nachstehenden Schritte (a) bis (f):

(a) Einstellen von Beschichtungsparametern an einer Beschichtungsanlage,
(b) Bereitstellen eines Substrats,
(c) Einsetzen des Substrats in die Beschichtungsanlage,
(d) Versehen des Substrats mit einer funktionellen Beschichtung in der Beschichtungsanlage, wodurch ein Brillenglas, aufweisend ein Substrat und eine als äußerste Schicht auf dem Substrat angeordnete funktionelle Beschichtung, erhalten wird,
(e) Entnehmen des Brillenglases aus der Beschichtungsanlage, und
(f) Bestimmen des haptischen Glattheitskoeffizienten HGK in Übereinstimmung mit dem Messverfahren nach einem der Punkte 1 bis 3 und/oder des haptischen Glattheitskoeffizienten R_HGK in Übereinstimmung mit dem Messverfahren nach Punkt 4.

13. Verfahren nach Punkt 12, weiter umfassend, nach Schritt (f), den nachstehenden Schritt (g):
(g) Ermitteln einer Abweichung des haptischen Glattheitskoeffizienten HGK und/oder des haptischen Glattheitskoeffizienten R_HGK von einem vorab festgelegten Soll-Wert, um auf Basis der ermittelten Abweichung gegebenenfalls die Beschichtungsparameter in Schritt (a) anzupassen.

14. Verfahren nach Punkt 12 oder 13, wobei in Schritt (d) das Versehen des Substrats mit einer funktionellen Beschichtung in der Beschichtungsanlage unter Verwendung einer die Verbindung (1) enthaltenden Quelle durch Verdampfen erfolgt.

15. Verfahren nach Punkt 14, wobei es sich bei der die Verbindung (1) enthaltenden Quelle um eine Tablette oder Pille, welche die Verbindung (1) in gebundener Form enthält, handelt.

16. Verfahren nach Punkt 14 oder 15, wobei das Verdampfen mit einer Verdampfungsrate in einem Bereich von 0,05 nm/s bis 3 nm/s erfolgt.

17. Verfahren nach einem der Punkte 14 bis 16, wobei das Verdampfen mit Hilfe eines thermischen Verdampfers erfolgt.

## Patentansprüche

1. Brillenglas, aufweisend ein Substrat und eine als äußerste Schicht auf dem Substrat angeordnete funktionelle Beschichtung,
**dadurch gekennzeichnet, dass** die funktionelle Beschichtung dem Brillenglas einen haptischen Glattheitskoeffizienten HGK von höchstens 0,28, bevorzugt von höchstens 0,25, und/oder einen haptischen Glattheitskoeffizienten R_HGK von höchstens 0,85, bevorzugt von höchstens 0,80, verleiht, wobei die Glattheitskoeffizienten HGK und R_HGK in Übereinstimmung mit einem Messverfahren zur Bestimmung der Glattheit eines Brillenglases mit Hilfe eines Rheometers unter Bestimmung dynamischer Reibungskoeffizienten gegenüber einem Mikrofasertuch, welches eine Kreisbahn um die Mitte des Brillenglases beschreibt, bestimmt werden, wobei die Bestimmung dynamischer Reibungskoeffizienten bei Geschwindigkeiten im Bereich von 0,005 m/s bis 0,4 m/s tangential zur beschriebenen Kreisbahn sowie tangential zur Oberfläche des Brillenglases erfolgt, und wobei das Verfahren umfasst:

Wischen mit einem Mikrofasertuch in einer rotierenden Bewegung um die Mitte des Brillenglases, wobei das Wischen mit Hilfe eines Rotors, der auf die konvexe Seite des Brillenglases abgesenkt wird, erfolgt, der Andruck des Mikrofasertuchs auf die zu messende Oberfläche des Brillenglases durch einen elastischen Stempel mit ringförmiger Auflagefläche geschieht, und sich das Mikrofasertuch im Bereich der ringförmigen Auflagefläche relativ zur Oberfläche des Brillenglases mit einer Geschwindigkeit im Bereich von 0,005 m/s bis 0,4 m/s tangential zum Außenradius der ringförmigen Auflagefläche bewegt,
Ermitteln des Drehmoments während der rotierenden Bewegung des Mikrofasertuchs mit Hilfe eines Rheometers,
Bestimmen des dynamischen Reibungskoeffizienten anhand des zuvor ermittelten Drehmoments,
Wiederholen der vorstehenden Schritte bei einer anderen Geschwindigkeit im Bereich von 0,005 m/s bis 0,4 m/s tangential zum Außenradius der ringförmigen Auflagefläche, und
Berechnen des haptischen Glattheitskoeffizienten HGK aus mindestens zwei mit verschiedenen tangentialen Geschwindigkeiten bestimmten dynamischen Reibungskoeffizienten,
wobei dynamische Reibungskoeffizienten, welche bei tangentialen Geschwindigkeiten von 0,20 m/s, 0,15 m/s und 0,07 m/s bestimmt werden, Eingang in die Berechnung des haptischen Glattheitskoeffizienten HGK finden, und der haptische Glattheitskoeffizient HGK anhand der nachstehenden Formel (XI) berechnet wird:

$$\mathrm{HGK} = 0{,}50 \times \mu_d(0{,}20\ \mathrm{m/s}) + 0{,}35 \times \mu_d(0{,}15\ \mathrm{m/s}) + 0{,}15 \times \mu_d(0{,}07\ \mathrm{m/s}) \quad \mathrm{(XI)}$$

worin $\mu_d(0{,}20\ \mathrm{m/s})$ der bei einer tangentialen Geschwindigkeit von 0,20 m/s bestimmte dynamische Reibungskoeffizient ist, $\mu_d(0{,}15\ \mathrm{m/s})$ der bei einer tangentialen Geschwindigkeit von 0,15 m/s bestimmte dynamische Reibungskoeffizient ist und $\mu_d(0{,}07\ \mathrm{m/s})$ der bei einer tangentialen Geschwindigkeit von 0,07 m/s bestimmte dynamische Reibungskoeffizient ist, und
wobei zusätzlich der dynamische Reibungskoeffizient bei einer tangentialen Geschwindigkeit von 0,01 m/s bestimmt wird und dieser Eingang in die Berechnung des haptischen Glattheitskoeffizienten R_HGK anhand der nachstehenden Formel (XII) findet:

$$\mathrm{R_HGK} = \mathrm{HGK} + 3 \times \mu_d(0{,}01\ \mathrm{m/s}) \quad \mathrm{(XII)}$$

worin $\mu_d(0{,}01\ \mathrm{m/s})$ der bei einer tangentialen Geschwindigkeit von 0,01 m/s bestimmte dynamische Reibungskoeffizient ist.

2. Brillenglas nach Anspruch 1, wobei die funktionelle Beschichtung aus einer Verbindung (1), umfassend einen perfluorierten Kohlenwasserstoffrest, welcher ein oder mehrere etherische Sauerstoffatome aufweist, und weiter umfassend mindestens eine Silylgruppe, welche mit einer oder mit mehreren hydrolysierbaren Gruppen substituiert sein kann, gebildet ist mit der Maßgabe, dass die Verbindung (1) mindestens zwei hydrolysierbare Gruppen enthält und durch die nachstehende Formel (A) dargestellt ist:

$$\mathrm{Rf}\left[\,\mathrm{Y} - \mathrm{X}\,\right]_a \quad \mathrm{(A)}$$

worin a 1 oder 2 ist, Rf einen Perfluoralkyletherrest, wenn a 1 ist, oder einen Perfluoralkylenetherrest, wenn a 2 ist, bezeichnet, X einen Rest mit mindestens einer Silylgruppe, welche mit einer oder mit mehreren hydrolysierbaren Gruppen substituiert sein kann, bezeichnet und Y einen optionalen Rest, welcher den Perfluoralkyl(en)etherrest Rf und den Rest X miteinander verknüpft, bezeichnet.

3. Brillenglas nach Anspruch 2, wobei die hydrolysierbaren Gruppen jeweils unabhängig voneinander aus der Gruppe, bestehend aus einer Alkoxygruppe mit 1 bis 10 Kohlenstoffatomen, einer Alkoxyalkoxygruppe mit 2 bis 10 Kohlenstoffatomen, einer Alkenyloxygruppe mit 2 bis 10 Kohlenstoffatomen, einer Acyloxygruppe mit 1 bis 10 Kohlenstoffatomen, einer Aminogruppe und einem Halogenatom, ausgewählt sind.

4. Brillenglas nach Anspruch 2 oder 3, wobei die hydrolysierbaren Gruppen jeweils unabhängig voneinander aus der Gruppe, bestehend aus einer Methoxygruppe, einer Ethoxygruppe, einer Isopropenoxygruppe und einem Chloratom, ausgewählt sind.

5. Brillenglas nach einem der Ansprüche 2 bis 4, wobei die durch die Formel (A) dargestellte Verbindung (1) Trimethoxysilan, welches einen Perfluoralkyletherrest umfasst, ist.

6. Brillenglas nach einem der Ansprüche 1 bis 5, wobei die Dicke der funktionellen Beschichtung in einem Bereich von 1 nm bis 100 nm liegt.

7. Brillenglas nach einem der Ansprüche 1 bis 6, wobei zwischen dem Substrat und der als äußerste Schicht auf dem Substrat angeordneten funktionellen Beschichtung ausgehend von der Oberfläche des Substrats mindestens eine weitere Schicht, ausgewählt aus der Gruppe, bestehend aus einer Grundierungsschicht, einer Hartschicht und einer Interferenz-/Entspiegelungsschicht, in der angegebenen Reihenfolge angeordnet ist.

8. Verfahren zur Herstellung eines Brillenglases, insbesondere zur Herstellung des Brillenglases nach einem der Ansprüche 1 bis 7, umfassend die nachstehenden Schritte (a) bis (f):

(a) Einstellen von Beschichtungsparametern an einer Beschichtungsanlage,
(b) Bereitstellen eines Substrats,
(c) Einsetzen des Substrats in die Beschichtungsanlage,
(d) Versehen des Substrats mit einer funktionellen Beschichtung in der Beschichtungsanlage, wodurch ein Brillenglas, aufweisend ein Substrat und eine als äußerste Schicht auf dem Substrat angeordnete funktionelle Beschichtung, erhalten wird,
(e) Entnehmen des Brillenglases aus der Beschichtungsanlage, und
(f) Bestimmen des haptischen Glattheitskoeffizienten HGK und/oder des haptischen Glattheitskoeffizienten R_HGK in Übereinstimmung mit dem Messverfahren gemäß Anspruch 1.

9. Verfahren nach Anspruch 8, weiter umfassend, nach Schritt (f), den nachstehenden Schritt (g):
(g) Ermitteln einer Abweichung des haptischen Glattheitskoeffizienten HGK und/oder des haptischen Glattheitskoeffizienten R_HGK von einem vorab festgelegten Soll-Wert, um auf Basis der ermittelten Abweichung gegebenenfalls die Beschichtungsparameter in Schritt (a) anzupassen.

10. Verfahren nach Anspruch 8 oder 9, wobei in Schritt (d) das Versehen des Substrats mit einer funktionellen Beschichtung in der Beschichtungsanlage unter Verwendung einer die Verbindung (1) enthaltenden Quelle durch Verdampfen erfolgt.

11. Verfahren nach Anspruch 10, wobei es sich bei der die Verbindung (1) enthaltenden Quelle um eine Tablette oder Pille, welche die Verbindung (1) in gebundener Form enthält, handelt.

12. Verfahren nach Anspruch 10 oder 11, wobei das Verdampfen mit einer Verdampfungsrate in einem Bereich von 0,05 nm/s bis 3 nm/s erfolgt.

13. Verfahren nach einem der Ansprüche 10 bis 12, wobei das Verdampfen mit Hilfe eines thermischen Verdampfers erfolgt.

Fig. 1

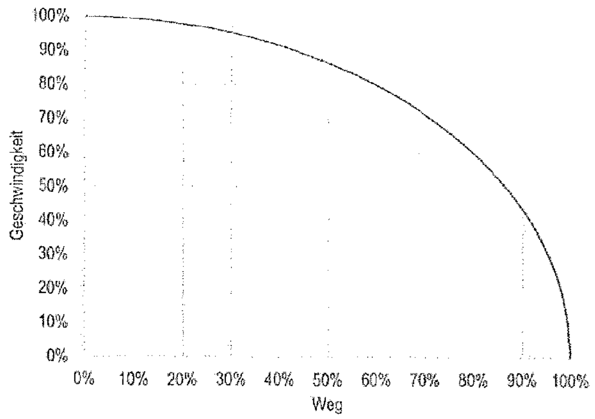
Geschwindigkeit
100%
90%
80%
70%
60%
50%
40%
30%
20%
10%
0%
0% 10% 20% 30% 40% 50% 60% 70% 80% 90% 100%
Weg

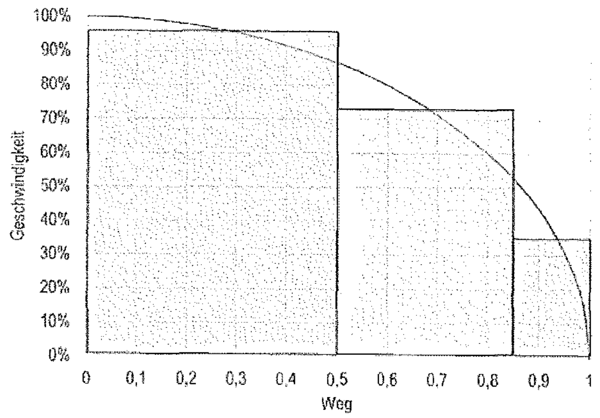
Geschwindigkeit
100%
90%
80%
70%
60%
50%
40%
30%
20%
10%
0%
0 0,1 0,2 0,3 0,4 0,5 0,6 0,7 0,8 0,9 1
Weg

Fig. 2

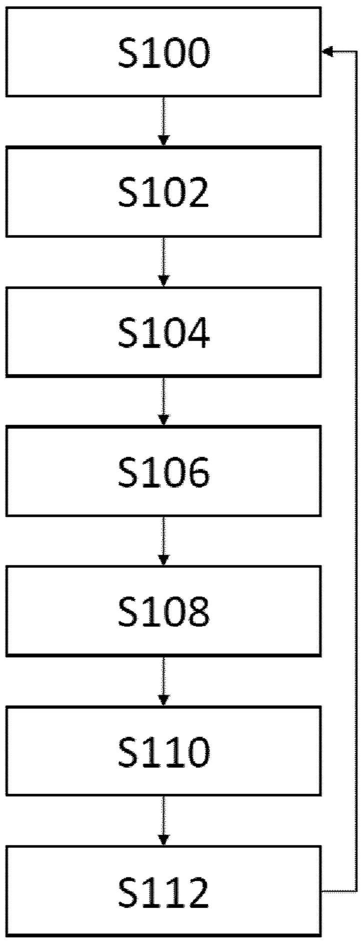

Fig. 3

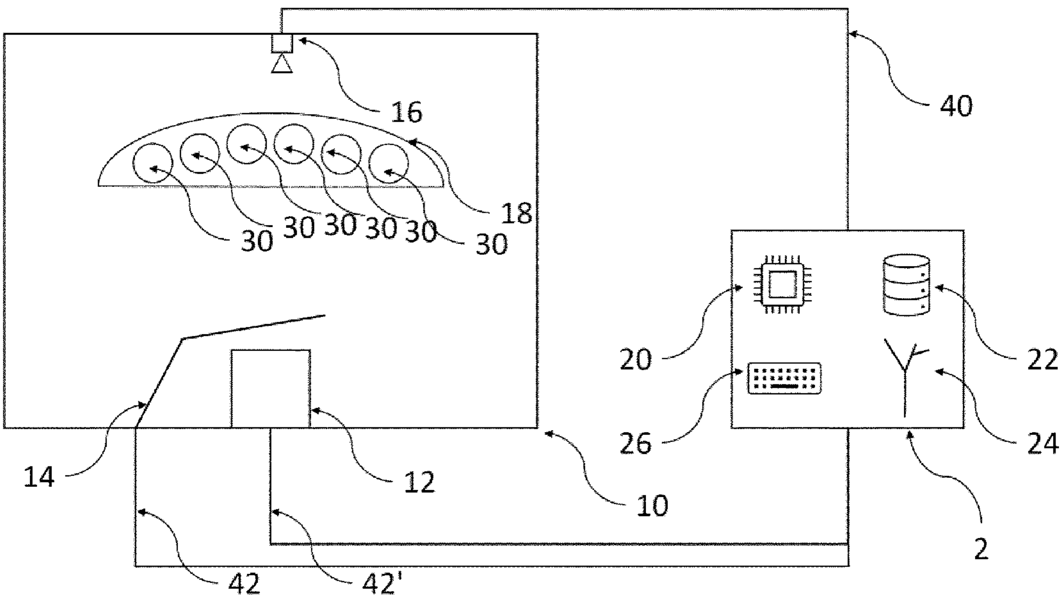

Fig. 4

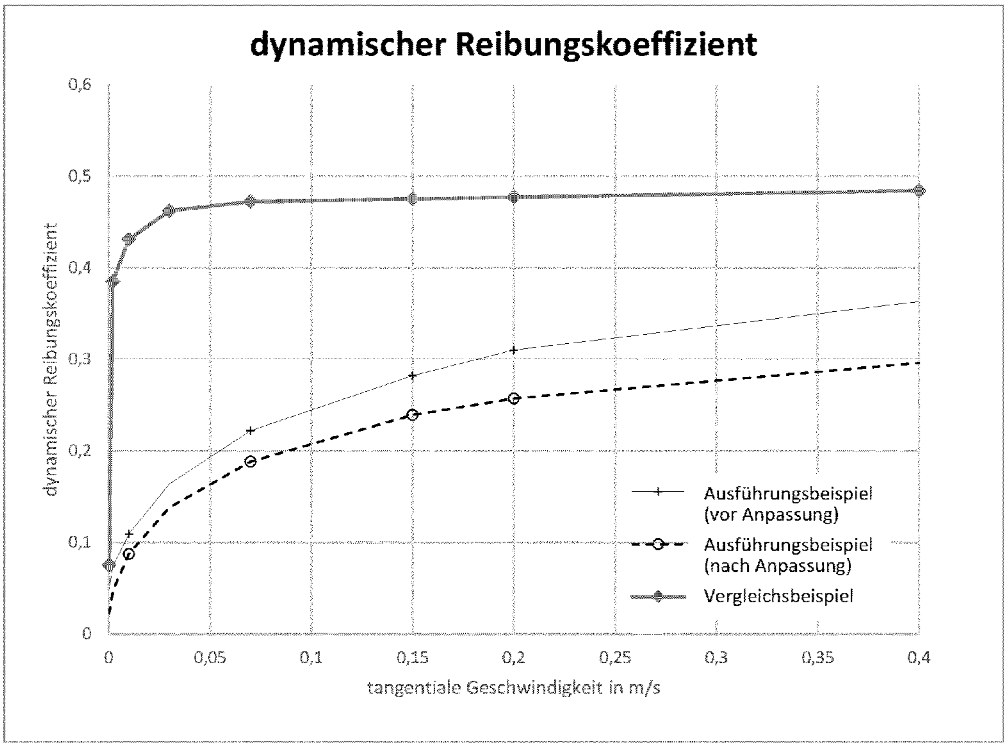
dynamischer Reibungskoeffizient
0,6
0,5
0,4
0,3
0,2
0,1
0
dynamischer Reibungskoeffizient
0
0,05
0,1
0,15
0,2
0,25
0,3
0,35
0,4
tangentiale Geschwindigkeit in m/s
Ausführungsbeispiel (vor Anpassung)
Ausführungsbeispiel (nach Anpassung)
Vergleichsbeispiel